# EUROPEAN PATENT SPECIFICATION

(11) **EP 4 489 087 B1**
(45) Date of publication and mention of the grant of the patent: **02.09.2026**
(21) Application number: 22929994.6
(22) Date of filing: 04.03.2022
(51) Int. Cl.: H10H 20/819, H10H 20/831, H10H 20/84, H10H 29/30

(54) **SEMICONDUCTOR LIGHT-EMITTING ELEMENT AND DISPLAY DEVICE**
LICHTEMITTIERENDES HALBLEITERELEMENT UND ANZEIGEVORRICHTUNG
ÉLÉMENT ÉLECTROLUMINESCENT À SEMI-CONDUCTEUR ET DISPOSITIF D'AFFICHAGE

(43) Date of publication of application: 08.01.2025
(73) Proprietor: LG Electronics Inc., Yeongdeungpo-gu Seoul 07336 (KR)
(72) Inventor: JEON, Jina, Seoul 06772 (KR)
(74) Representative: Vossius & Partner Patentanwälte Rechtsanwälte mbB
(86) International application number: PCT/KR2022/003106
(87) International publication number: WO 2023/167350

(56) References cited:
- WO-A1-2021/246537
- JP-A- 2014 241 401
- KR-A- 20190 105 537
- KR-A- 20200 023 316
- KR-A- 20200 023 319
- KR-A- 20200 026 760
- KR-A- 20200 057 216
- KR-A- 20200 095 210
- US-A1- 2016 099 383
- US-A1- 2016 190 396
- US-A1- 2017 373 228
- US-A1- 2020 168 589
- US-A1- 2020 395 509

## Description

### [Technical field]

The present invention relates to a semiconductor light-emitting element and a display device.

### [Background art]

A large-area display includes a liquid crystal display (LCD), an OLED display, a micro-LED display, etc. US 2020/395509 A1, KR 20200026760 A, KR 20200023316 A, KR 20200023319 A and US 2017/373228 A1 form part of the related art.

A micro-LED display is a display that uses a micro-LED, which is a semiconductor light-emitting element with a diameter or cross-sectional area of 100*µ*m or less, as a display element.

Since a micro-LED display uses a micro-LED, which is a semiconductor light-emitting element, as a display element, it has excellent performance in many characteristics such as contrast ratio, response speed, color reproducibility, viewing angle, brightness, resolution, lifespan, luminous efficiency, luminance, etc.

In particular, a micro-LED display has the advantage of being able to freely adjust the size or resolution by separating and combining the screen in a modular manner, and the advantage of being able to implement a flexible display.

However, since a large micro-LED display requires millions or more micro-LEDs, there is a technical problem that makes it difficult to quickly and accurately transfer micro-LEDs to the display panel.

Recently developed transfer technologies include the pick and place process, the laser lift-off method, or the self-assembly method.

Among these, the self-assembly method is a method in which semiconductor light-emitting elements find their assembly positions in a fluid on their own, which is advantageous for implementing a large-screen display device.

Meanwhile, according to a non-public internal technology, light-emitting elements assembled on a substrate by the self-assembly method are electrically connected by the thermal compression method. That is, the bonding layer provided at a lower part of the light-emitting element melts by the thermal compression and is electrically connected to the electrical wiring of the substrate.

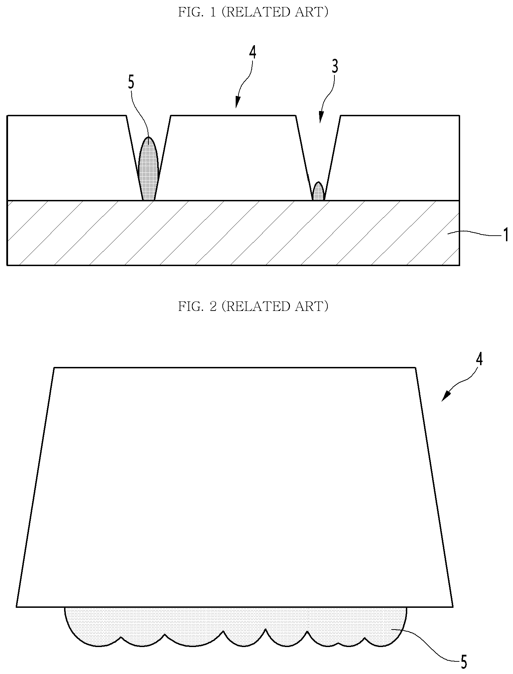

However, the thermal compression method using the bonding layer has the following problems. The problems will be explained with reference to FIGS. 1 to 4.

FIG. 1 illustrates a bonding material escaping around a light-emitting element.

As illustrated in FIG. 1, when the light-emitting element 4 is assembled in the assembly hole 3 and then the light-emitting element 4 is thermally compressed, the bonding material 5 on the lower side of the light-emitting element 4 escapes around the light-emitting element 4 rather than staying between the light-emitting element 4 and the substrate 1. In this way, the bonding material 5 escapes around the light-emitting element 4, and some of the bonding material 5 forms a sharp spire as high as the light-emitting element 4. When the electrode wiring (not illustrated) is disposed on the upper side of the light-emitting element 4 by a post-process, the electrode wiring electrically contacts the bonding material 5, causing a problem in which the upper and lower parts of the light-emitting element 5 are electrically short-circuited.

FIG. 2 is a cross-sectional view illustrating a light-emitting element according to a non-public internal technology.

As shown in FIG. 2, a bonding material 5 is provided on the lower side of the light-emitting element according to the non-public internal technology. That is, the non-public internal technology does not have a structure that prevents the bonding material 5 from escaping laterally during thermal compression.

Therefore, when the light-emitting element according to the non-public internal technology illustrated in FIG. 2 is thermally compressed on the substrate 1 using the thermal compression method as illustrated in FIG. 1, the bonding material 5 melted by the heat generated during the thermal compression process does not remain on the lower side of the light-emitting element 4 but escapes around the light-emitting element 4.

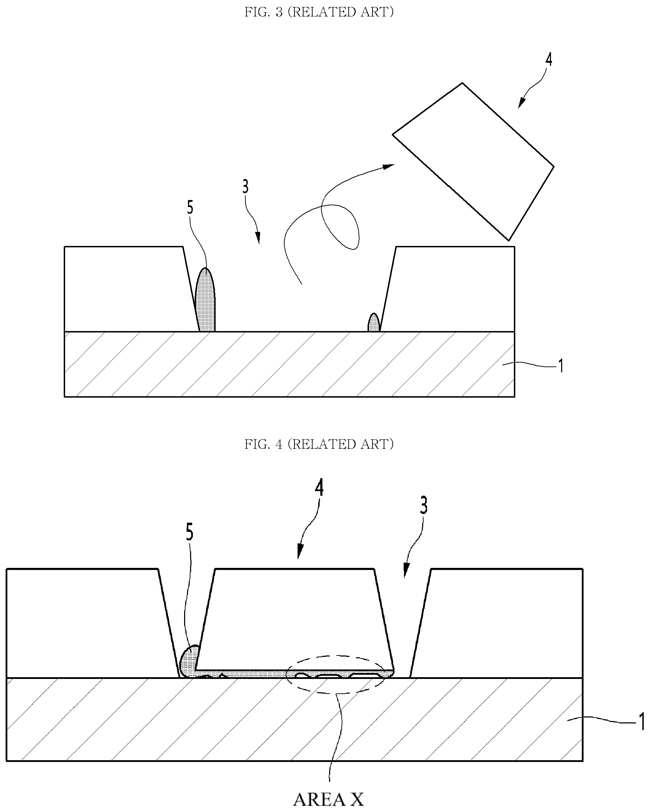

FIG. 3 illustrates the appearance of the light-emitting element being detached.

In the case where the bonding material 5 escapes around the light-emitting element 4, since there is almost no bonding material 5 between the light-emitting element 4 and the substrate 1, as illustrated in FIG. 3, the light-emitting element 4 is detached without being attached to the substrate 1. That is, the light-emitting element 5 is attached to the substrate 1 by the bonding material 5. In order for the light-emitting element 5 to be strongly attached to the substrate 1, a bonding material 5 must exist on the lower side of the light-emitting element 5 despite the thermal compression. However, during the thermal compression, most of the bonding material 5 provided on the lower side of the light-emitting element 5 escapes around the light-emitting element 5, and only a small amount of bonding material 5 remains on the lower side of the light-emitting element 5. Therefore, since the light-emitting element 5 is not strongly attached to the substrate 1, there is a problem in that the light-emitting element 5 is easily detached from the substrate 1. The detachment of the light-emitting element 5 reduces the assembly rate and causes assembly failure or lighting failure.

FIG. 4 illustrates a poor electrical connection of the electrical wiring between the light-emitting element and the substrate.

As shown in FIG. 4, when the bonding material 5 escapes around the light-emitting element 4 by thermal compression, there is almost no bonding material 5 remaining on the lower side of the light-emitting element 4 (see area X), and thus, the light-emitting element 4 and the substrate 1 are poorly electrically connected via the bonding material 5. In other words, since the bonding material 5 does not exist continuously between the light-emitting element 4 and the substrate 1 but exists locally, the electrical connection between the light-emitting element 4 and the substrate 1 is also locally connected. This leads to an increase in electrical resistance between the light-emitting element 4 and the substrate 1, so that the electrical signal of the substrate 1 is not easily supplied to the light-emitting element 4, resulting in a problem of reduced brightness.

Meanwhile, during thermal compression, a press having a heater on the upper side of the light-emitting element presses the light-emitting element, and at this time, the heat of the heater melts the bonding material provided on the lower side of the light-emitting element through the light-emitting element. Usually, the heat of the heater is supplied to the lower side of the light-emitting element through the center of the light-emitting element more intensively than the periphery of the light-emitting element, so that the melting point between the bonding material corresponding to the center of the light-emitting element and the bonding material corresponding to the periphery of the light-emitting element is different. In other words, the melting point is different depending on the position of the bonding material, and this becomes a factor that restricts a smooth bonding process. In other words, the bonding process time is lengthened or bonding failure occurs.

### [Disclosure]

### [Technical Problem]

An object of the present invention is to solve the foregoing and other problems.

Another object of the present invention is to provide a semiconductor light-emitting element and a display device having a novel structure that does not require solder metal.

In addition, another object of the present invention is to provide a semiconductor light-emitting element and a display device that can prevent contact failure.

In addition, another object of the present invention is to provide a semiconductor light-emitting element and a display device that can prevent assembly failure and lighting failure.

The technical problems of the present invention are not limited to those described in this item and comprise those that can be understood through the description of the invention.

### [Technical Solution]

The present invention is specified in the independent claims. Preferred embodiments are defined in the dependent claims. In the following description, although numerous features may be designated as optional, it is nevertheless acknowledged that all features comprised in the independent claims are not to be read as optional. According to one aspect of the present invention to achieve the above or other purposes, a semiconductor light-emitting element according to claim 1 is provided.

The first electrode comprises a third conductive layer under the first region. The third conductive layer is disposed under the first conductive layer.

The first conductive layer is an ultraviolet-ray blocking layer The first conductive layer may furthermore be an electrode layer, a visible-light transmitting layer, or a heat absorption layer

The second conductive layer may be an electrode layer, and the third conductive layer may be a magnetic layer.

A step portion may be provided between the first region and the second region. The width of the step portion may be a difference value between the diameter of the second region and the diameter of the first region. The second conductive layer may be disposed in the step portion.

The light-emitting portion comprises a first conductivity-type semiconductor layer, an active layer on the first conductivity-type semiconductor layer; and a second conductivity-type semiconductor layer on the active layer, and the first region may comprise the first conductivity-type semiconductor layer, and the second region may comprise the active layer and the second conductivity-type semiconductor layer.

According to another aspect of the present invention, a display device according to claim 7 is provided.

Each of the plurality of first electrode wirings may be connected to at least one or more conductive layer of the first conductive layer, the second conductive layer, or the third conductive layer, and the plurality of second electrode wirings may be connected to the second electrodes of the plurality of semiconductor light-emitting elements, respectively.

According to another aspect of the present invention, a display device according to claim 9 is provided.

The connection electrode may connect at least one or more of the first assembling wiring or the second assembling wiring to at least one of the first conductive layer, the second conductive layer, or the third conductive layer.

### [Advantageous Effects]

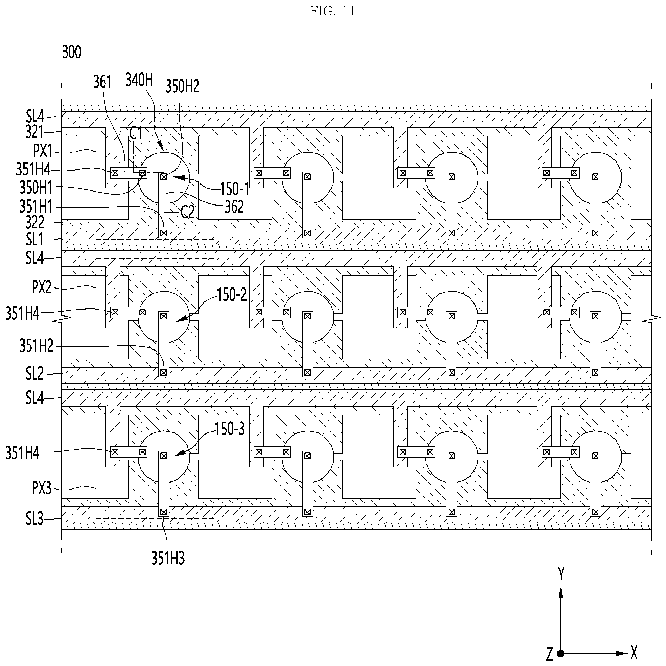

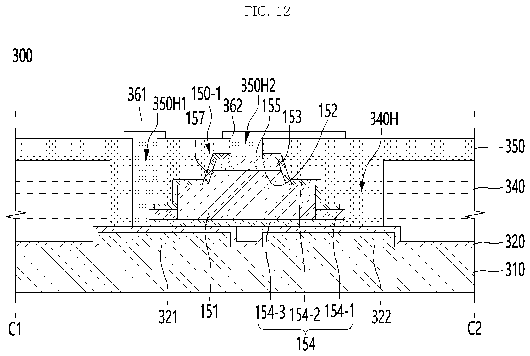

As shown in FIG. 11 and FIG. 12, the embodiment disposes the first electrode wiring 361 and the second electrode wiring 362 on the same surface, thereby simplifying the structure and facilitating electrical connectivity with the signal line.

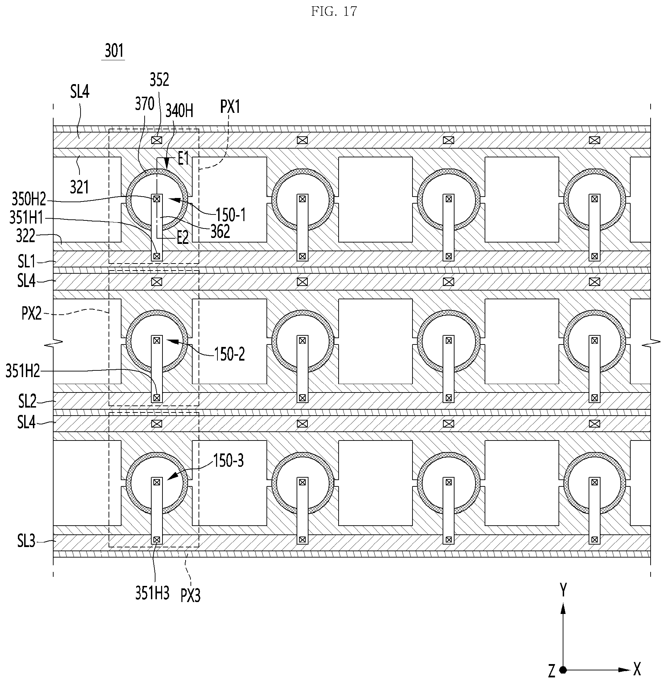

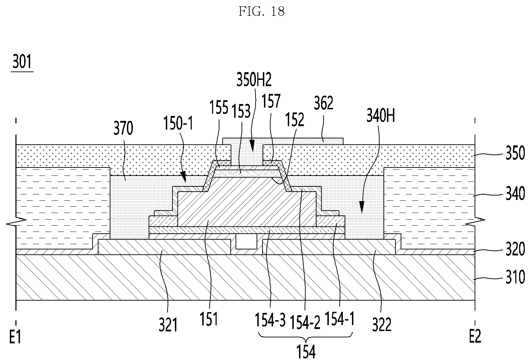

As illustrated in FIGS. 17 and 18, the embodiment may use the first assembling wiring 321 and/or the second assembling wiring 322 as electrode wiring, so that the assembling wirings 321 and 322 do not need to be formed separately, and thus the structure can be simple. At this time, the connection electrode 370 may be in surface contact with the outer surface of the first conductivity-type semiconductor layer 151 of the semiconductor light-emitting elements 150-1, 150-2, and 150-3 along the perimeter of the first conductivity-type semiconductor layer 151 of each of the semiconductor light-emitting elements 150-1, 150-2, and 150-3, so that the light efficiency may be improved by a smoother current flow.

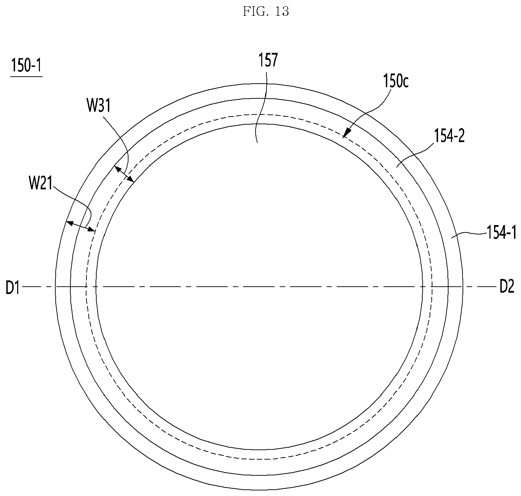

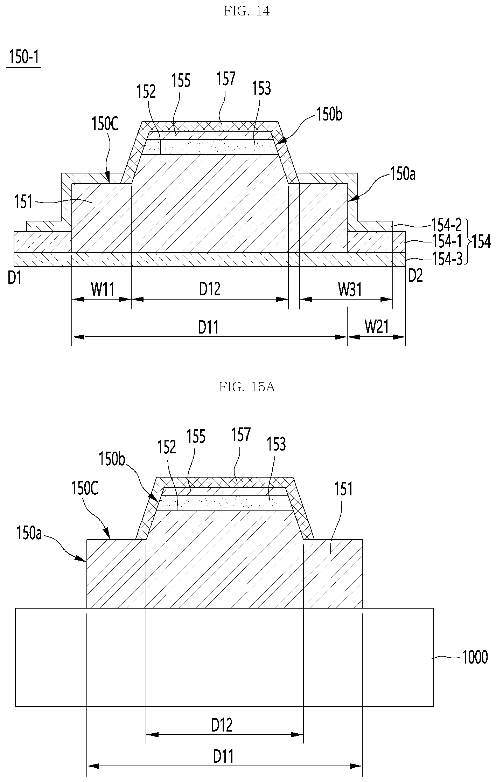

As illustrated in FIGS. 13 and 14, the embodiment may comprise the third conductive layer 154-3 constituting the first electrode 154 of the semiconductor light-emitting element 150-1. The third conductive layer 154-3 may be a magnetic layer, and may be disposed not only under the first region 150a but also under the first conductive layer 154-1 having a ring shape, so that its area is expanded, and thus the magnetization of the third conductive layer 154-3 can be increased, and thus the assembly yield can be significantly improved. In addition, since the third conductive layer 154-3 comprises a metal, it can also serve as an electrode layer for allowing current to flow smoothly.

Meanwhile, the embodiment can have various technical advantages as follows, since the first conductive layer 154-1 constituting the first electrode 154 of the semiconductor light-emitting element 150-1 nay be disposed along the perimeter of the first region 150a and between the second conductive layer 154-2 and the third conductive layer 154-3.

The first conductive layer 154-1 can be an electrode layer. That is, the first conductive layer 154-1 may be formed of a conductive oxide material having excellent electrical conductivity. Accordingly, current may easily flow from the first region 150a to the first conductive layer 154-1. In particular, since the first conductive layer 154-1 is disposed along the perimeter of the first region 150a, current may flow to the first electrode wiring 361 through the first conductive layer 154-1 in the entire region of the first region 150a. Accordingly, more electrons may be generated in the first region 150a, i.e., the first conductivity-type semiconductor layer 151, which may contribute to improving light efficiency.

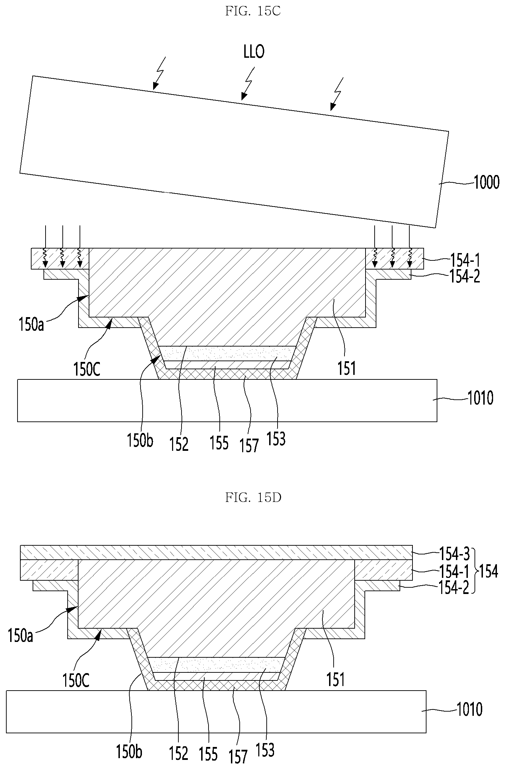

In addition, the second conductive layer 154-2 may be an ultraviolet-ray blocking layer or a visible-light transmitting layer. For example, since the wavelength of the laser beam used in the LLO process (FIG. 15C) in the manufacturing process of the semiconductor light-emitting element 150-1 is an ultraviolet wavelength, when the laser beam is irradiated, the laser beam may be blocked by the first conductive layer 154-1, so that the laser beam does not penetrate through the first conductive layer 154-1 and may be irradiated to the second conductive layer 154-2, and thus the second conductive layer 154-2 can be protected from the laser beam. For example, since the color light emitted from the semiconductor light-emitting element 150-1 has a visible-light wavelength, the color light can penetrate through the first conductive layer 154-1 and be emitted to the outside. As illustrated in FIG. 12, when color light is emitted through the first conductive layer 154-1 in the semiconductor light-emitting element, the color light may be refracted or reflected by the inner surface of the first assembling wiring 231, the second assembling wiring 232, or the partition wall 340 and may be emitted forward, so that uniform light output can be possible and light efficiency can be improved.

In addition, the first conductive layer 154-1 may be a heat absorption layer. During the manufacturing process of the semiconductor light-emitting element 150-1, the first substrate 1000 and the semiconductor light-emitting element 150-1 may be separated from each other by the LLO process (FIG. 15C). At this time, when the first conductive layer 154-1 is irradiated with a laser beam, the first conductive layer 154-1 may absorb the laser beam and convert it into heat, so that the temperature can rapidly increase due to the heat within the first conductive layer 154-1. As such, the rapidly-increased temperature can be transferred to the interface between the first substrate 1000 and the semiconductor light-emitting element 150-1 through the first region 150a, thereby promoting separation between the first substrate 1000 and the semiconductor light-emitting element 150-1.

Meanwhile, in the embodiment, the first conductive layer 154-1, the second conductive layer 154-2, and/or the third conductive layer 154-3, which constitute the first electrode 154, may be disposed around the lower side of the semiconductor light-emitting element 150-1, so that the current may flow from the entire area of the first region 150a to the first electrode wiring 361 through the first conductive layer 154-1, the second conductive layer 154-2, and/or the third conductive layer 154-3, so that the light efficiency can be improved through the generation of more electrons in the first region 150a, i.e., the first conductivity-type semiconductor layer 151.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 illustrates a bonding material escaping around a light-emitting element.
FIG. 2 is a cross-sectional view illustrating a light-emitting element according to a non-public internal technology.
FIG. 3 illustrates a light-emitting element being detached.
FIG. 4 illustrates an electrical connection failure of electrical wiring between a light-emitting element and a substrate.
FIG. 5 illustrates a living room of a house in which a display device according to an embodiment is disposed.
FIG. 6 is a block diagram schematically illustrating a display device according to an embodiment.
FIG. 7 is a circuit diagram illustrating an example of a pixel of FIG. 6.
FIG. 8 is an enlarged view of a first panel area in the display device of FIG. 5.
FIG. 9 is an enlarged view of an area A2 of FIG. 8.
FIG. 10 is a drawing illustrating an example in which a light-emitting element according to an embodiment is assembled to a substrate by a self-assembly method.
FIG. 11 is a plan view illustrating a display device according to the first embodiment.
FIG. 12 is a cross-sectional view taken along the C1-C2 line of FIG. 11.
FIG. 13 is a plan view illustrating a semiconductor light-emitting element according to the embodiment.
FIG. 14 is a cross-sectional view taken along the D1-D2 line of FIG. 13.
Figs. 15A to 15E illustrate a manufacturing process of a semiconductor light-emitting element according to the embodiment.
FIG. 16 shows the light transmittance according to the wavelength of ITO.
FIG. 17 is a plan view illustrating a display device according to the second embodiment.
FIG. 18 is a cross-sectional view taken along the E1-E2 line of FIG. 17.

The sizes, shapes, dimensions, etc. of elements shown in the drawings can differ from actual ones. In addition, even if the same elements are shown in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

The display device described in this specification may comprise a TV, a signage, a mobile phone, a smart phone, a head-up display (HUD) for a car, a backlight unit for a laptop computer, a display for VR or AR, etc. However, the configuration according to the embodiment described in this specification may be applied to a device capable of displaying, even if it is a new product type developed in the future.

The following describes a light-emitting element according to an embodiment and a display device comprising the same.

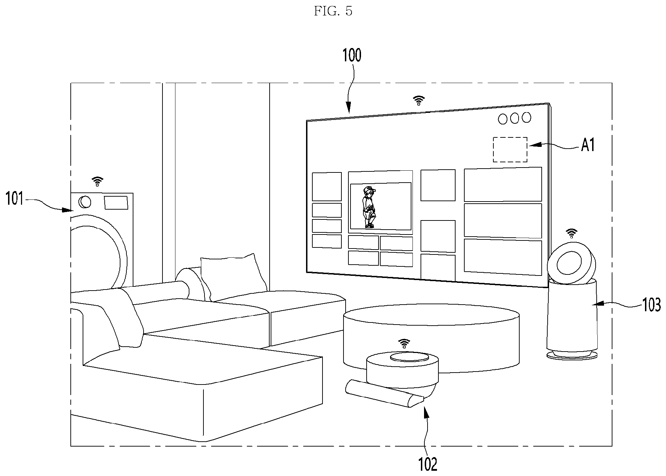

FIG. 5 illustrates a living room of a house in which a display device according to an embodiment is disposed.

Referring to FIG. 5, the display device 100 according to the embodiment can display the status of various electronic products such as a washing machine 101, a robot vacuum cleaner 102, and an air purifier 103, and can communicate with each electronic product based on IoT and control each electronic product based on user setting data.

The display device 100 according to the embodiment may comprise a flexible display manufactured on a thin and flexible substrate. A flexible display can be bent or rolled like paper while maintaining the characteristics of an existing flat panel display.

In a flexible display, visual information can be implemented by independently controlling the light emission of unit pixels disposed in a matrix form. A unit pixel means a minimum unit for implementing one color. A unit pixel of a flexible display can be implemented by a light-emitting element. In an embodiment, the light-emitting element may be a Micro-LED or a Nano-LED, but is not limited thereto.

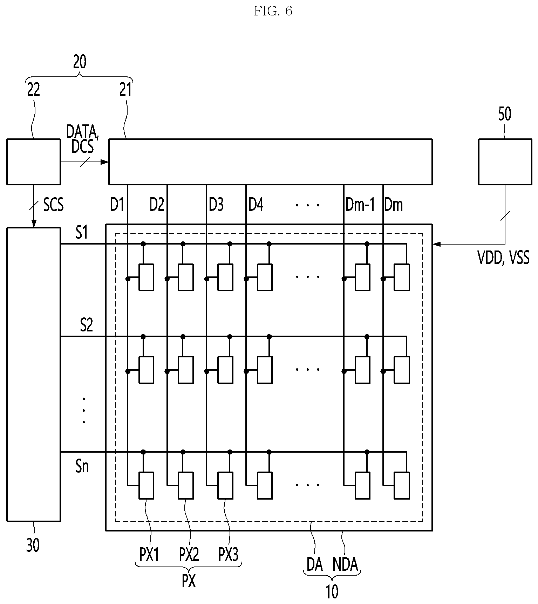

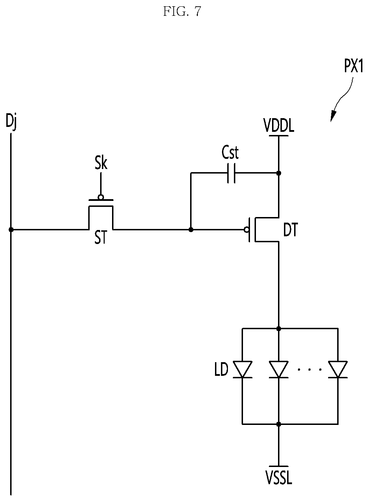

FIG. 6 is a block diagram schematically showing a display device according to an embodiment, and FIG. 7 is a circuit diagram showing an example of a pixel of FIG. 6.

Referring to FIGS. 6 and 7, the display device according to the embodiment may comprise a display panel 10, a driving circuit 20, a scan driving unit 30, and a power supply circuit 50.

The display device 100 of the embodiment may drive a light-emitting element in an active matrix (AM) method or a passive matrix (PM) method.

The driving circuit 20 may comprise a data driving unit 21 and a timing control unit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel 10 can be divided into a display area DA and a non-display area NDA disposed around the display area DA. The display area DA is an area where pixels PX are formed to display an image. The display panel 10 can comprise data lines (D1 to Dm, m is an integer greater than or equal to 2), scan lines (S1 to Sn, n is an integer greater than or equal to 2) crossing the data lines D1 to Dm, a high-potential voltage line VDDL to which a high-potential voltage is supplied, a low-potential voltage line VSSL to which a low-potential voltage is supplied, and pixels PX connected to the data lines D1 to Dm and the scan lines S1 to Sn.

Each of the pixels PX can comprise a first sub-pixel PX1, a second sub-pixel PX2, and a third sub-pixel PX3. The first sub-pixel PX1 can emit a first color light of a first main wavelength, the second sub-pixel PX2 can emit a second color light of a second main wavelength, and the third sub-pixel PX3 can emit a third color light of a third main wavelength. The first color light can be red light, the second color light can be green light, and the third color light can be blue light, but is not limited thereto. In addition, FIG. 6 exemplifies that each of the pixels PX comprises three sub-pixels, but is not limited thereto. That is, each of the pixels PX can comprise four or more sub-pixels.

Each of the first sub-pixel PX1, the second sub-pixel PX2, and the third sub-pixel PX3 can be connected to at least one of the data lines D1 to Dm, at least one of the scan lines S1 to Sn, and a high-potential voltage line VDDL. The first sub-pixel PX1 may comprise light-emitting elements LD, a plurality of transistors for supplying current to the light-emitting elements LD, as shown in FIG. 7, and at least one capacitor Cst.

Although not illustrate in the drawing, each of the first sub-pixel PX1, the second sub-pixel PX2, and the third sub-pixel PX3 may comprise only one light-emitting element LD and at least one capacitor Cst.

Each of the light-emitting elements LD may be a semiconductor light-emitting diode comprising a first electrode, a plurality of conductivity-type semiconductor layers, and a second electrode. Here, the first electrode may be an anode electrode, and the second electrode may be a cathode electrode, but is not limited thereto.

The light-emitting element LD may be one of a lateral-type light-emitting element, a flip-chip light-emitting element, and a vertical-type light-emitting element.

The plurality of transistors may comprise a driving transistor DT for supplying current to the light-emitting elements LD, as shown in FIG. 7, and a scan transistor ST for supplying a data voltage to a gate electrode of the driving transistor DT. The driving transistor DT may comprise a gate electrode connected to the source electrode of the scan transistor ST, a source electrode connected to a high-potential voltage line VDDL to which a high-potential voltage is applied, and a drain electrode connected to the first electrodes of the light-emitting elements LD. The scan transistor ST may comprise a gate electrode connected to a scan line (Sk, where k is an integer satisfying 1 ≤ k ≤ n), a source electrode connected to the gate electrode of the driving transistor DT, and a drain electrode connected to a data line (Dj, where j is an integer satisfying 1 ≤ j ≤ m).

A capacitor Cst is formed between the gate electrode and the source electrode of the driving transistor DT. The storage capacitor Cst charges a difference value between the gate voltage and the source voltage of the driving transistor DT.

The driving transistor DT and the scan transistor ST may be formed of a thin film transistor. In addition, in FIG. 7, the driving transistor DT and the scan transistor ST are described mainly as being formed as P-type MOSFETs (Metal Oxide Semiconductor Field Effect Transistors), but the present invention is not limited thereto. The driving transistor DT and the scan transistor ST may also be formed as N-type MOSFETs. In this case, the positions of the source electrodes and the drain electrodes of each of the driving transistor DT and the scan transistor STs may be changed.

In addition, in FIG. 7, the first sub-pixel PX1, the second sub-pixel PX2, and the third sub-pixel PX3 are illustrated as comprising 2T1C (2 Transistor - 1 capacitor) having one driving transistor DT, one scan transistor ST, and one capacitor Cst, but the present invention is not limited thereto. The first sub-pixel PX1, the second sub-pixel PX2, and the third sub-pixel PX3 may each comprise a plurality of scan transistors STs and a plurality of capacitors Csts.

Since the second sub-pixel PX2 and the third sub-pixel PX3 can be expressed by substantially the same circuit diagram as the first sub-pixel PX1, a detailed description thereof is omitted.

The driving circuit 20 outputs signals and voltages for driving the display panel 10. To this end, the driving circuit 20 may comprise a data driving unit 21 and a timing control unit 22.

The data driving unit 21 receives digital video data DATA and a source control signal DCS from the timing control unit 22. The data driving unit 21 converts the digital video data DATA into analog data voltages according to the source control signal DCS and supplies the same to the data lines D1 to Dm of the display panel 10.

The timing control unit 22 receives digital video data DATA and timing signals from the host system. The timing signals may comprise a vertical synchronization signal, a horizontal synchronization signal, a data enable signal, and a dot clock. The host system may be an application processor of a smartphone or tablet PC, a monitor, a system on chip of a TV, etc.

The timing control unit 22 generates control signals for controlling the operation timing of the data driver 21 and the scan driver 30. The control signals may comprise a source control signal DCS for controlling the operation timing of the data driver 21 and a scan control signal SCS for controlling the operation timing of the scan driver 30.

The driving circuit 20 may be disposed in a non-display area NDA provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but the present invention is not limited thereto. For example, the driving circuit 20 may be mounted on a circuit board (not shown) other than the display panel 10.

The data driving unit 21 may be mounted on the display panel 10 using a chip on glass (COG) method, a chip on plastic (COP) method, or an ultrasonic bonding method, and the timing control unit 22 may be mounted on the circuit board.

The scan driving unit 30 receives a scan control signal SCS from the timing control unit 22. The scan driving unit 30 generates scan signals according to the scan control signal SCS and supplies the scan signals to the scan lines S1 to Sn of the display panel 10. The scan driving unit 30 may comprise a plurality of transistors and may be formed in a non-display area NDA of the display panel 10. Alternatively, the scan driver 30 may be formed as an integrated circuit, in which case it may be mounted on a gate flexible film attached to the other side of the display panel 10.

The circuit board may be attached to pads provided on one edge area of the display panel 10 using an anisotropic conductive film. As a result, lead lines of the circuit board may be electrically connected to the pads. The circuit board may be a flexible film such as a flexible printed circuit board, a printed circuit board, or a chip on film. The circuit board may be bent to the lower part of the display panel 10. As a result, one side of the circuit board may be attached to one edge area of the display panel 10, and the other side may be disposed on the lower part of the display panel 10 and connected to a system board on which a host system is mounted.

The power supply circuit 50 can generate voltages required for driving the display panel 10 from the main power applied from the system board and supply them to the display panel 10. For example, the power supply circuit 50 can generate a high-potential voltage VDD and a low-potential voltage VSS for driving light-emitting elements LD of the display panel 10 from the main power and supply them to a high-potential voltage line VDDL and a low-potential voltage line VSSL of the display panel 10. In addition, the power supply circuit 50 can generate and supply driving voltages for driving the driving circuit 20 and the scan driving unit 30 from the main power.

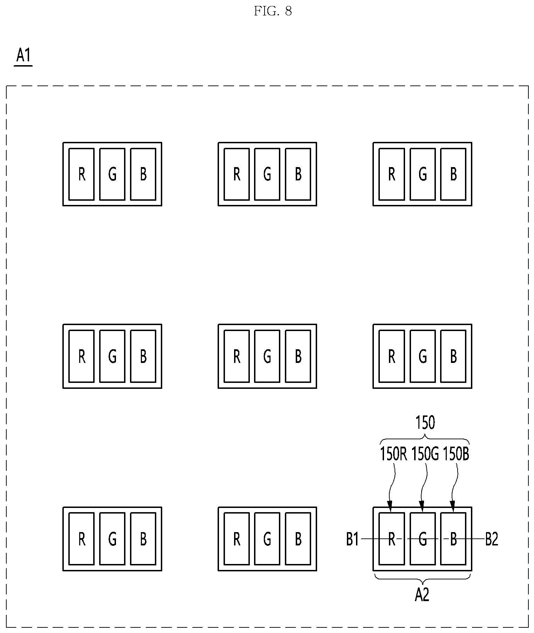

FIG. 8 is an enlarged view of the first panel area in the display device of FIG. 3.

Referring to FIG. 8, the display device 100 of the embodiment can be manufactured by mechanically and electrically connecting a plurality of panel areas such as the first panel area A1 by tiling.

The first panel area A1 can comprise a plurality of semiconductor light-emitting elements 150 disposed for each unit pixel (PX of FIG. 6).

For example, the unit pixel PX can comprise a first sub-pixel PX1, a second sub-pixel PX2, and a third sub-pixel PX3. For example, a plurality of first semiconductor light-emitting elements 150R may be disposed in a first sub-pixel PX1, a plurality of second semiconductor light-emitting elements 150G may be disposed in a second sub-pixel PX2, and a plurality of third semiconductor light-emitting elements 150B may be disposed in a third sub-pixel PX3. The unit pixel PX may further comprise a fourth sub-pixel in which no semiconductor light-emitting elements are disposed, but is not limited thereto.

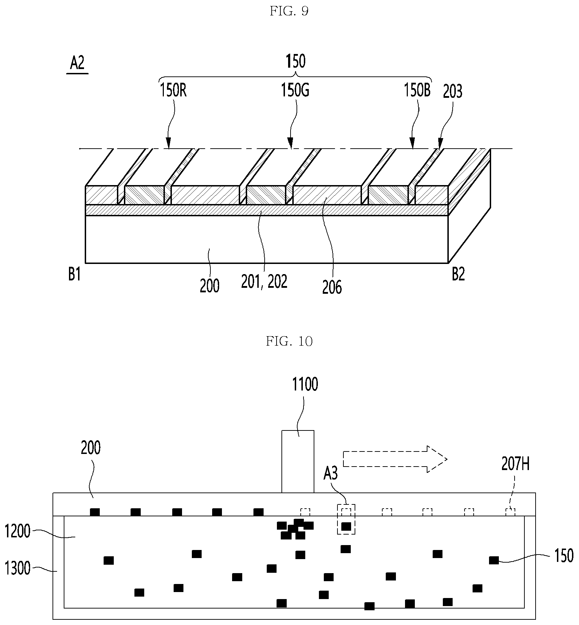

FIG. 9 is an enlarged view of the A2 region of FIG. 8.

Referring to FIG. 9, the display device 100 of the embodiment may comprise a substrate 200, assembling wirings 201 and 202, an insulating layer 206, and a plurality of semiconductor light-emitting elements 150. More components may be included than these.

The assembling wiring may comprise a first assembling wiring 201 and a second assembling wiring 202 that are spaced apart from each other. The first assembling wiring 201 and the second assembling wiring 202 may be provided to generate a dielectrophoretic force (DEP force) to assemble the semiconductor light-emitting element 150. For example, the semiconductor light-emitting element 150 may be one of a lateral-type semiconductor light-emitting element, a flip-chip type semiconductor light-emitting element, and a vertical-type semiconductor light-emitting element.

The semiconductor light-emitting element 150 may comprise, but is not limited thereto, a first semiconductor light-emitting element 150, a second semiconductor light-emitting element 150G, and a third semiconductor light-emitting element 150B to form a unit pixel (sub-pixel), and may also comprise a red phosphor and a green phosphor to implement red and green, respectively.

The substrate 200 may be a support member that supports components disposed on the substrate 200 or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN) or Polyethylene Terephthalate (PET). In addition, the substrate 200 may be a transparent material, but is not limited thereto. The substrate 200 may function as a support substrate in a display panel, and may also function as an assembling substrate when self-assembling a light-emitting element.

The substrate 200 may be a backplane equipped with circuits, such as transistors ST and DT, capacitors Cst, and signal wiring, within the sub-pixels PX1, PX2, and PX3 illustrated in FIGS. 6 and 7, but is not limited thereto.

The insulating layer 206 may comprise an organic material having insulation and flexibility, such as polyimide, PAC, PEN, PET, polymer, or an inorganic material such as silicon oxide (SiO₂) or silicon nitride series (SiNₓ), and may be formed integrally with the substrate 200 to form a single substrate.

The insulating layer 206 may be a conductive adhesive layer having adhesion and conductivity, and the conductive adhesive layer may have flexibility to enable a flexible function of the display device. For example, the insulating layer 206 may be a conductive adhesive layer such as an anisotropic conductive film (ACF) or an anisotropic conductive medium, a solution containing conductive particles, etc. The conductive adhesive layer may be a layer that is electrically conductive in a direction vertical to the thickness, but electrically insulating in a direction horizontal to the thickness.

The insulating layer 206 may comprise an assembly hole 203 for inserting a semiconductor light-emitting element 150. Therefore, when self-assembling, the semiconductor light-emitting element 150 can be easily inserted into the assembly hole 203 of the insulating layer 206. The assembly hole 203 may be called an insertion hole, a fixing hole, an alignment hole, etc. The assembly hole 203 may also be called a hole.

The assembly hole 203 may be called a hole, a groove, a recess, a pocket, etc.

The assembly hole 203 may be different depending on the shape of the semiconductor light-emitting element 150. For example, the first semiconductor light-emitting element, the second semiconductor light-emitting element, and the third semiconductor light-emitting element each have different shapes, and may have an assembly hole 203 having a shape corresponding to each of the shapes of these semiconductor light-emitting elements. For example, the assembly hole 203 may comprise a first assembly hole for assembling the first semiconductor light-emitting element, a second assembly hole for assembling the second semiconductor light-emitting element, and a third assembly hole for assembling the third semiconductor light-emitting element. For example, the first semiconductor light-emitting element may have a circular shape, the second semiconductor light-emitting element may have a first oval shape having a first minor axis and a second major axis, and the third semiconductor light-emitting element may have a second oval shape having a second minor axis and a second major axis, but is not limited thereto. The second major axis of the ellipse of the third semiconductor light-emitting element may be greater than the second major axis of the ellipse of the second semiconductor light-emitting element, and the second minor axis of the ellipse of the third semiconductor light-emitting element may be smaller than the first minor axis of the ellipse of the second semiconductor light-emitting element.

Meanwhile, the method of mounting the semiconductor light-emitting element 150 on the substrate 200 may comprise, for example, a self-assembly method (FIG. 10) and a transfer method.

FIG. 10 is a drawing showing an example in which a light-emitting element according to an embodiment is assembled on a substrate by a self-assembly method.

Based on FIG. 10, an example in which a semiconductor light-emitting element according to an embodiment is assembled on a display panel by a self-assembly method using an electromagnetic field will be described.

The assembling substrate 200 described below can also function as a panel board 200a in a display device after assembling the light-emitting element, but the embodiment is not limited thereto.

Referring to FIG. 10, the semiconductor light-emitting element 150 can be put into a chamber 1300 filled with a fluid 1200, and the semiconductor light-emitting element 150 can be moved to the assembling substrate 200 by a magnetic field generated from the assembly device 1100. At this time, the light-emitting element 150 adjacent to the assembly hole 207H of the assembling substrate 200 can be assembled into the assembly hole 207H by the DEP force caused by the electric field of the assembling wirings. The fluid 1200 can be water such as ultrapure water, but is not limited thereto. The chamber can be called a tank, a container, a vessel, etc.

After the semiconductor light-emitting element 150 is put into the chamber 1300, the assembling substrate 200 can be disposed on the chamber 1300. According to an embodiment, the assembling substrate 200 may be put into the chamber 1300.

After the assembling substrate 200 is disposed in the chamber, an assembly device 1100 that applies a magnetic field may move along the assembling substrate 200. The assembly device 1100 may be a permanent magnet or an electromagnet.

The assembly device 1100 may move in contact with the assembling substrate 200 to maximize the area affected by the magnetic field within the fluid 1200. According to an embodiment, the assembly device 1100 may comprise a plurality of magnetic bodies or may comprise magnetic bodies of a size corresponding to the assembling substrate 200. In this case, the movement distance of the assembly device 1100 may be limited within a predetermined range.

The semiconductor light-emitting element 150 within the chamber 1300 may move toward the assembly device 1100 and the assembling substrate 200 by the magnetic field generated by the assembly device 1100.

The semiconductor light-emitting element 150 may be fixed by entering the assembly hole 207H by the DEP force formed by the electric field between the assembling wirings 201 and 202 while moving toward the assembly device 1100.

Specifically, the first and second assembling wirings 201 and 202 form an electric field by an AC power source, and the DEP force may be formed between the assembling wirings 201 and 202 by this electric field. The semiconductor light-emitting element 150 may be fixed to the assembly hole 207H on the assembling substrate 200 by this DEP force.

At this time, a predetermined solder layer (not shown) may be formed between the light-emitting element 150 assembled on the assembly hole 207H of the assembling substrate 200 and the assembling wirings 201 and 202 to improve the bonding strength of the light-emitting element 150.

In addition, a molding layer (not shown) may be formed in the assembly hole 207H of the assembling substrate 200 after assembly. The molding layer may be a transparent resin or a resin containing a reflective material or a scattering material.

Since the time required for each semiconductor light-emitting element to be assembled on the substrate can be drastically shortened by the self-assembly method using the electromagnetic field described above, a large-area high-pixel display can be implemented more quickly and economically.

Hereinafter, various embodiments for solving the above-described problem will be described with reference to FIGS. 11 to 18. Any description omitted below can be easily understood from the description described above with respect to FIGS. 1 to 10 and the corresponding drawings.

### [First Embodiment]

FIG. 11 is a plan view illustrating a display device according to the first embodiment. FIG. 12 is a cross-sectional view taken along the C1-C2 line of FIG. 11.

Referring to FIGS. 11 and 12, the display device 300 according to the first embodiment may comprise a substrate 310, a plurality of first assembling wirings 321, a plurality of second assembling wirings 322, a partition wall 340, a plurality of semiconductor light-emitting elements 150-1, 150-2, and 150-3, a plurality of first electrode wirings 361, and a plurality of second electrode wirings 362. The display device 300 according to the first embodiment may comprise more components than these.

The substrate 310 may comprise a plurality of sub-pixels PX1, PX2, and PX3.

The plurality of sub-pixels may comprise a plurality of first sub-pixels PX1 arranged along a first direction X. The plurality of first sub-pixels PX1 may each emit the same color light, i.e., a first color light.

For example, the plurality of sub-pixels may comprise a plurality of second sub-pixels PX2 adjacent to each of the plurality of first sub-pixels PX1 along the second direction Y and arranged along the first direction X. The plurality of second sub-pixels PX2 may each emit the same color light, i.e., a second color light.

For example, the plurality of sub-pixels may comprise a plurality of third sub-pixels PX3 adjacent to each of the plurality of second sub-pixels PX2 along the second direction Y and arranged along the first direction X. The plurality of third sub-pixels PX3 may emit the same color light, i.e., a third color light.

The first color light may be red light, the second color light may be green light, and the third color light may be blue light, but is not limited thereto. The first sub-pixel PX1, the second sub-pixel PX2, and the third sub-pixel PX3 arranged along the second direction Y may constitute a unit pixel capable of displaying a full color image. Accordingly, a large-area image may be displayed by arranging the plurality of unit pixels on the substrate 310.

The substrate 310 may be a supporting member that supports components disposed on the substrate 310 or a protective member that protects the components. Since the substrate 310 has been described above, it will be omitted.

The first and second assembling wirings 321 and 322 may be disposed on the substrate 310. That is, the plurality of sub-pixels PX1, PX2, and PX3 may each comprise the first assembling wiring 321 and the second assembling wiring 322. The first and second assembling wirings 321 and 322 may play a role in assembling the semiconductor light-emitting element 150-1 into the assembly hole 340H in a self-assembly manner. That is, when self-assembling, an electric field may be generated between the first assembling wiring 321 and the second assembling wiring 322 by the voltage supplied to the first and second assembling wirings 321 and 322, and the semiconductor light-emitting element 150-1 moving by the assembly device (1100 of FIG. 10) may be assembled into the assembly hole 340H by the dielectrophoretic force formed by the electric field.

The same assembling wiring of each of the plurality of sub-pixels PX1, PX2, and PX3 may be formed integrally. For example, the second assembling wiring 322 of the first sub-pixel PX1 may be formed integrally with the second assembling wiring 322 of the second sub-pixel PX2. For example, the first assembling wiring 321 of the second sub-pixel PX2 may be formed integrally with the first assembling wiring 321 of the third sub-pixel PX3.

The first assembling wiring 321 and the second assembling wiring 322 may be disposed on the same layer. That is, the first assembling wiring 321 and the second assembling wiring 322 may be disposed between the substrate 310 and the first insulating layer 320. In this case, the first assembling wiring 321 and the second assembling wiring 322 may be disposed to be spaced apart from each other to prevent electrical short circuit.

Although the drawing illustrates that the first assembling wiring 321 and the second assembling wiring 322 are disposed on the same layer, they may be disposed on different layers.

For example, the first assembling wiring 321 may be disposed under the first insulation layer 320, and the second assembling wiring 322 may be disposed on the first insulation layer 320. In this case, the upper surface of the second assembling wiring 322 may be exposed to the outside, i.e., to the assembly hole 340H. For example, the second assembling wiring 322 may form a part of a bottom portion of the assembly hole 340H. When the semiconductor light-emitting element 150-1 is assembled into the assembly hole 340H, the lower side of the semiconductor light-emitting element 150-1 may come into contact with the upper surface of the second assembling wiring 322 in the assembly hole 340H.

Referring back to FIG. 12, the first insulating layer 320 may be disposed on the first assembling wiring 321 and the second assembling wiring 322. For example, the first insulating layer 320 may prevent the first assembling wiring 321 and the second assembling wiring 322 from being electrically shorted by a foreign substance. For example, the first insulating layer 320 may be made of a material having a permittivity, and may contribute to the formation of a dielectrophoretic force. For example, the first insulating layer 320 may be made of an inorganic material or an organic material. For example, the first insulating layer 320 may be made of a material having a permittivity related to a dielectrophoretic force.

The partition wall 340 may be disposed on the substrate 310 and may have an assembly hole 340H. Each of the plurality of sub-pixels PX1, PX2, and PX3 may comprise at least one or more assembly hole 340H. The partition wall 340 may be disposed on the first assembling wiring 321 and the second assembling wiring 322. For example, the assembly hole 340H may be provided on the first assembling wiring 321 and the second assembling wiring 322. The thickness of the partition wall 340 may be determined in consideration of the thickness of the semiconductor light-emitting element 150-1. For example, the thickness of the partition wall 340 may be smaller than the thickness of the semiconductor light-emitting element 150-1. Accordingly, the upper side of the semiconductor light-emitting element 150-1 may be positioned higher than the upper surface of the partition wall 340. That is, the upper side of the semiconductor light-emitting element 150-1 may protrude upward from the upper surface of the partition wall 340.

Each of the plurality of semiconductor light-emitting elements 150-1, 150-2, and 150-3 can be assembled into the assembly hole 340H by the dielectrophoretic force formed between the first assembling wiring 321 and the second assembling wiring 322 in each of the plurality of sub-pixels PX1, PX2, and PX3. For example, one semiconductor light-emitting element can be assembled into the assembly hole 340H.

The size of the assembly hole 340H can be determined by considering a tolerance margin for forming the assembly hole 340H and a margin for easily assembling the semiconductor light-emitting elements 150-1, 150-2, and 150-3 within the assembly hole 340H. For example, the size of the assembly hole 340H can be greater than the sizes of the semiconductor light-emitting elements 150-1, 150-2, and 150-3. For example, when the semiconductor light-emitting elements 150-1, 150-2, and 150-3 are assembled at the center of the assembly hole 340H, the distance between the outer side of the semiconductor light-emitting elements 150-1, 150-2, and 150-3 and the inner side of the assembly hole 340H may be 2*µ*m or less, but is not limited thereto.

For example, the assembly hole 340H may have a shape corresponding to the shape of the semiconductor light-emitting elements 150-1, 150-2, and 150-3. For example, when the semiconductor light-emitting elements 150-1, 150-2, and 150-3 are circular, the assembly hole 340H may also be circular. For example, when the semiconductor light-emitting elements 150-1, 150-2, and 150-3 are rectangular, the assembly hole 340H may also be rectangular.

As an example, the assembly holes 340H in each of the first sub-pixel PX1, the second sub-pixel PX2, and the third sub-pixel PX3 may have the same shape, i.e., a circle. In this case, the first semiconductor light-emitting element 150-1 disposed in the first sub-pixel PX1, the second semiconductor light-emitting element 150-2 disposed in the second sub-pixel PX2, and the third semiconductor light-emitting element 150-3 disposed in the third sub-pixel PX3 may have a shape corresponding to the assembly hole 340H, i.e., a circular shape.

In this way, when the assembly holes 340H of the first sub-pixel PX1, the second sub-pixel PX2, and the third sub-pixel PX3 have the same shape, the first semiconductor light-emitting element 150-1, the second semiconductor light-emitting element 150-2, and the third semiconductor light-emitting element 150-3 can be sequentially assembled into the assembly holes 340H of the corresponding sub-pixels PX1, PX2, and PX3, but are not limited thereto. For example, the first semiconductor light-emitting element 150-1 can be assembled into the assembly hole 340H of the first sub-pixel PX1 of the substrate 310, the second semiconductor light-emitting element 150-2 can be assembled into the assembly hole 340H of the second sub-pixel PX2 of the substrate 310, and the third semiconductor light-emitting element 150-3 can be assembled into the assembly hole 340H of the third sub-pixel PX3 of the substrate 310. In this case, the shapes of the first semiconductor light-emitting element 150-1, the second semiconductor light-emitting element 150-2, and the third semiconductor light-emitting element 150-3 may be the same, but are not limited thereto. The assembly holes 340H may have the shapes corresponding to the shapes of the first semiconductor light-emitting element 150-1, the second semiconductor light-emitting element 150-2, and the third semiconductor light-emitting element 150-3, respectively, but may have the sizes greater than the sizes of the first semiconductor light-emitting element 150-1, the second semiconductor light-emitting element 150-2, and the third semiconductor light-emitting element 150-3, respectively.

As another example, the assembly holes 340H in each of the first sub-pixel PX1, the second sub-pixel PX2, and the third sub-pixel PX3 may have different shapes. For example, the assembly hole 340H in the first sub-pixel PX1 may have a circular shape, the assembly hole 340H in the second sub-pixel PX2 may have a first oval shape having a first minor axis and a first major axis, and the assembly hole 340H in the third sub-pixel PX3 may have a second oval shape having a second minor axis smaller than the first minor axis and a second major axis greater than the first major axis. In this case, the first semiconductor light-emitting element 150-1 may have a shape corresponding to the assembly hole 340H of the first sub-pixel PX1, that is, a circular shape, the second semiconductor light-emitting element 150-2 may have a shape corresponding to the assembly hole 340H of the second sub-pixel PX2, that is, a first oval shape, and the third semiconductor light-emitting element 150-3 may have a shape corresponding to the assembly hole 340H of the third sub-pixel PX3, that is, a second oval shape.

In this way, by means of the assembly holes 340H having different shapes and the first to third semiconductor light-emitting elements 150-1, 150-2 and 150-3 having shapes corresponding to the assembly holes 340H, the first to third semiconductor light-emitting elements 150-1, 150-2 and 150-3 can be assembled into the corresponding assembly holes 340H at the same time during self-assembly. That is, even if the first semiconductor light-emitting element 150-1, the second semiconductor light-emitting element 150-2 and the third semiconductor light-emitting element 150-3 are mixed in the fluid 1200 for self-assembly, the semiconductor elements corresponding to the assembly holes 340H of the first sub-pixel PX1, the second sub-pixel PX2 and the third sub-pixel PX3 on the substrate can be assembled. That is, a first semiconductor light-emitting element 150-1 having a shape corresponding to the shape of the assembly hole 340H of the first sub-pixel PX1 can be assembled. A second semiconductor light-emitting element 150-2 having a shape corresponding to the shape of the assembly hole 340H can be assembled into the assembly hole 340H of the second sub-pixel PX2. A third semiconductor light-emitting element 150-3 having a shape corresponding to the shape of the assembly hole 340H can be assembled into the assembly hole 340H of the third sub-pixel PX3. Accordingly, since each of the first semiconductor light-emitting element 150-1, the second semiconductor light-emitting element 150-2, and the third semiconductor light-emitting element 150-3 having different shapes is assembled into the assembly hole 340H corresponding to its own shape, assembly failure can be prevented.

Meanwhile, the plurality of semiconductor light-emitting elements may comprise a first semiconductor light-emitting element 150-1 that emits a first color light, a second semiconductor light-emitting element 150-2 that emits a second color light, and a third semiconductor light-emitting element 150-3 that emits a third color light. For example, at least one or more first semiconductor light-emitting element 150-1 may be disposed in each of a plurality of first sub-pixels PX1 arranged along the first direction. For example, at least one or more second semiconductor light-emitting element 150-2 may be disposed in each of a plurality of second sub-pixels PX2 arranged along the first direction. For example, at least one or more third semiconductor light-emitting element 150-3 may be disposed in each of a plurality of third sub-pixels PX3 arranged along the first direction.

A plurality of first electrode wirings 361 and a plurality of second electrode wirings 362 may be disposed on the upper side of each of the plurality of semiconductor light-emitting elements 150-1, 150-2, and 150-3. Each of the first sub-pixel PX1, the second sub-pixel PX2, and the third sub-pixel PX3 may comprise the first electrode wiring 361 and the second electrode wiring 362.

For example, the first electrode wiring 361 and the second electrode wiring 362 may be disposed on the upper side of the first semiconductor light-emitting element 150-1 disposed in the first sub-pixel PX1. The first electrode wiring 361 may be connected to the first side of the first semiconductor light-emitting element 150-1 through the first contact hole 350H1, and the second electrode wiring 362 may be connected to the second side of the first semiconductor light-emitting element 150-1 through the second contact hole 350H2. For example, the first electrode wiring 361 and the second electrode wiring 362 may be disposed on an upper side of the second semiconductor light-emitting element 150-2 disposed in the second sub-pixel PX2. The first electrode wiring 361 may be connected to a first side of the second semiconductor light-emitting element 150-2 through the first contact hole 350H1, and the second electrode wiring 362 may be connected to a second side of the second semiconductor light-emitting element 150-2 through the second contact hole 350H2. For example, the first electrode wiring 361 and the second electrode wiring 362 may be disposed on an upper side of the third semiconductor light-emitting element 150-3 disposed in the third sub-pixel PX3. The first electrode wiring 361 may be connected to the first side of the third semiconductor light-emitting element 150-3 through the first contact hole 350H1, and the second electrode wiring 362 may be connected to the second side of the third semiconductor light-emitting element 150-3 through the second contact hole 350H2.

The first electrode wiring 361 and the second electrode wiring 362 may be disposed on the same layer. For example, the first electrode wiring 361 and the second electrode wiring 362 may be disposed on the second insulating layer 350.

For example, the second electrode wiring 362 may be made of a transparent conductive material that allows light to pass through. For example, the second electrode wiring 362 may comprise ITO, IZO, etc., but is not limited thereto.

The first electrode wiring 361 may be made of the same material as the second electrode wiring 362. Alternatively, the first electrode wiring 361 may be made of a different material from the second electrode wiring 362. For example, the first electrode wiring 361 may be made of a metal having excellent electrical conductivity. The first electrode wiring 361 may have a multi-layer structure.

The second insulating layer 350 may be disposed on the partition wall 340 to protect the semiconductor light-emitting element 150-1. The second insulating layer 350 may be disposed in the assembly hole 340H around the semiconductor light-emitting element 150-1 to firmly fix the semiconductor light-emitting element 150-1. In addition, the second insulating layer 350 may be disposed on the semiconductor light-emitting element 150-1 to protect the semiconductor light-emitting element 150-1 from external impact and prevent contamination by foreign substances.

The second insulating layer 350 may serve as a planarization layer that enables a layer formed in a subsequent process to be formed with a constant thickness. Accordingly, the upper surface of the second insulating layer 350 may have a flat surface. The second insulating layer 350 may be formed of an organic material or an inorganic material. Accordingly, the first electrode wiring 361 and the second electrode wiring 362 may be easily formed on the upper surface of the second insulating layer having a flat surface without a short circuit.

The semiconductor light-emitting element may emit light by power supplied by the first electrode wiring 361 and the second electrode wiring 362.

Meanwhile, in the embodiment, the structure of the semiconductor light-emitting element may be changed so that it may be easily connected to the first electrode wiring 361 and the second electrode wiring 362. Referring to FIGS. 13 and 14, the semiconductor light-emitting element of the embodiment will be described.

FIG. 13 is a plan view illustrating a semiconductor light-emitting element according to the embodiment. FIG. 14 is a cross-sectional view taken along the line D1-D2 of FIG. 13.

Referring to FIGS. 13 and 14, the semiconductor light-emitting element 150-1 according to the embodiment may comprise light-emitting portion 151, 152, and 153, a first electrode 154, a second electrode 155, and a passivation layer 157. The semiconductor light-emitting element 150-1 according to the embodiment may comprise more components than these.

The light-emitting portion 151, 152, and 153 may emit light of a predetermined color. The light-emitting portion comprise a first conductivity-type semiconductor layer 151, an active layer 152, and a second conductivity-type semiconductor layer 153, but may comprise more components than these. That is, each of the first conductivity-type semiconductor layer 151, the active layer 152, and the second conductivity-type semiconductor layer 153 may comprise a plurality of layers.

The first conductivity-type semiconductor layer 151, the active layer 152, and the second conductivity-type semiconductor layer 153 can be sequentially grown on a wafer (not shown) using deposition equipment such as MOCVD. That is, the first conductivity-type semiconductor layer 151 can be grown, then the active layer 152 can be grown on the first conductivity-type semiconductor layer 151, and then the second conductivity-type semiconductor layer 153 can be grown on the active layer 152. Thereafter, the second conductivity-type semiconductor layer 153, the active layer 152, and the first conductivity-type semiconductor layer 151 can be etched in the vertical direction in this order using an etching process. Through this etching process, a plurality of light-emitting portions 151, 152, and 153 can be spaced apart from each other on the substrate (1000 in FIG. 15A), and the substrate 1000 can be removed, thereby separating the plurality of light-emitting portions 151, 152, and 153.

Through this etching process, light-emitting portion 151, 152, and 153 having various shapes can be formed. For example, as illustrated in FIG. 14, the diameter D11 of the first region 150a may be greater than the diameter D12 of the second region 150b, and the light-emitting portion 151, 152, and 153 having a step portion 150c having a width W11 equal to the difference between the diameter D12 of the first region 150a and the diameter D12 of the second region 150b can be formed. As another example, although not shown, the light-emitting portion 151, 152, and 153 may be formed in a mesa structure with a diameter that gradually decreases from the lower side to the upper side of the light-emitting portion 151, 152, and 153.

The first conductivity-type semiconductor layer 151 may comprise a first conductive dopant, and the second conductivity-type semiconductor layer 153 may comprise a second conductive dopant. For example, the first conductive dopant may be an n-type dopant such as silicon (Si), and the second conductive dopant may be a p-type dopant such as boron (B).

For example, the first conductivity-type semiconductor layer 151 may generate electrons, and the second conductivity-type semiconductor layer 153 may form holes. The active layer 152 may be called an emitting layer because it generates light by recombination of electrons and holes.

The first electrode 154 may be disposed around the lower side of the light-emitting portion 151, 152, and 153. For example, the first electrode 154 may be disposed on a portion of the side portion of the light-emitting portion 151, 152, and 153. For example, the first electrode 154 may be disposed on the lower side of the light-emitting portion 151, 152, and 153.

The first electrode 154 may comprise a plurality of layers. For example, the first electrode 154 may comprise a first conductive layer 154-1, a second conductive layer 154-2, and a third conductive layer 154-3, but may comprise more layers than these. That is, although not shown, the first electrode 154 may further comprise a reflective layer, an adhesive layer, a barrier layer, etc.

The second electrode 155 may be disposed on the light-emitting portion 151, 152, and 153. For example, the second electrode 155 may be disposed on the second conductivity-type semiconductor layer 153. The second electrode 155 may comprise a plurality of layers.

For example, the second electrode 155 may comprise a transparent conductive layer, etc. The transparent conductive layer may be made of, for example, ITO, IZO, etc. A current spreading effect may be obtained in which a current supplied from the electrode wiring 360 is evenly spread over the entire region of the second conductivity-type semiconductor layer 153 by the transparent conductive layer. That is, since the current is evenly spread over the entire region of the second conductivity-type semiconductor layer 153 by the transparent conductive layer, holes are generated in the entire region of the second conductivity-type semiconductor layer 153, thereby increasing the amount of holes generated and increasing the amount of light generated by the recombination of holes and electrons in the active layer 152, thereby increasing light efficiency. An increase in light efficiency may lead to an improvement in luminance.

The passivation layer 157 may protect the light-emitting portion 151, 152, and 153. The passivation layer 157 can reduce power consumption by blocking leakage current flowing on the outer surfaces of the light-emitting portion 151, 152, and 153, and can prevent an electrical short between the side surface of the first conductivity-type semiconductor layer 151 and the side surface of the second conductivity-type semiconductor layer 153 due to foreign substances.

For example, the passivation layer 157 can surround the light-emitting portion 151, 152, and 153. For example, the passivation layer 157 can surround the second electrode 155. For example, the passivation layer 157 can be disposed along the perimeter of the side surfaces of the light-emitting portion 151, 152, and 153 and can be disposed on the second electrode 155. In an embodiment, the passivation layer 157 can be disposed around a portion of the second region 150b of the light-emitting portion 151, 152, and 153.

The passivation layer 157 can ensure that the semiconductor light-emitting element 150-1 is not turned over during self-assembly, and that the lower side of the semiconductor light-emitting element 150-1, that is, the lower side of the first conductivity-type semiconductor layer 151, faces the upper side of the first insulating layer 320. That is, the passivation layer 157 of the semiconductor light-emitting element 150-1 can be positioned away from the first assembling wiring 321 and the second assembling wiring 322 during self-assembly. Since the passivation layer 157 is not disposed on the lower side of the semiconductor light-emitting element 150-1, the lower side of the semiconductor light-emitting element 150-1 can be positioned close to the first assembling wiring 321 and the second assembling wiring 322. Therefore, when self-assembling, the lower side of the semiconductor light-emitting element 150-1 may be positioned facing the first insulating layer 320, and the upper side of the semiconductor light-emitting element 150-1 may be positioned facing upward, so that mis-alignment in which the semiconductor light-emitting element 150-1 is assembled upside down can be prevented.

The drawing shows that the upper sides of the light-emitting portion 151, 152, and 153 are covered by the passivation layer 157, but is not limited thereto. That is, a portion of the passivation layer 157 on the upper sides of the light-emitting portion 151, 152, and 153 can be removed, so that an opening can be formed in which the upper sides of the light-emitting portion 151, 152, and 153 are exposed. In this way, after a semiconductor light-emitting element 150-1 having light-emitting portion 151, 152, and 153 with openings formed therein is assembled on a substrate 310 using a self-assembly process, a second electrode wiring (362 in FIG. 12) can be connected through the openings.

Meanwhile, in the embodiment, the light-emitting portion 151, 152, and 153 can comprise a first region 150a and a second region 150b. The second region 150b can be located on the first region 150a. For example, the first region 150a can comprise a first conductivity-type semiconductor layer 151. For example, the second region 150b can comprise an active layer 152 and a second conductivity-type semiconductor layer 153. For example, the second region 150b can comprise a portion of the first conductivity-type semiconductor layer 151. The first region 150a may be referred to as the first structure, and the second region 150b may be referred to as the second structure.

The first region 150a and the second region 150b may have different diameters D11 and D12. For example, the diameter D11 of the first region 150a may be greater than the diameter D12 of the second region 150b. For example, the first region 150a may have a cylindrical shape having a side surface that is perpendicular to the ground, and the second region 150b may have a mesa shape having a side surface that is inclined to the ground. That is, the diameter D12 of the second region 150b may gradually decrease from the lower side to the upper side.

In an embodiment, the light-emitting portion 151, 152, and 153 may have a step portion 150c. The step portion 150c may be formed by the difference in diameters D11 and D12 between the first region 150a and the second region 150b. The width W11 of the step portion 150c may be a difference value between the diameter D11 of the first region 150a and the diameter D12 of the second region 150b.

A portion of the first region 150a may vertically overlap with the second region 150b, and another portion of the first region 150a may not vertically overlap with the second region 150b. The upper surface of the other portion of the first region 150a that does not vertically overlap with the second region 150b may be defined as the step portion 150c. Therefore, the step portion 150c may have a ring shape along the perimeter of the second region 150b.

For example, the first electrode 154 may be disposed on the first region 150a, and the second electrode 155 may be disposed on the second region 150b. In addition, the passivation layer 157 may be disposed on the second region 150b. For example, the second electrode 155 may be disposed on the upper side of the second region 150b, and the passivation layer 157 may be disposed along the perimeter of the side portion of the second region 150b and disposed on the second electrode 155. Accordingly, the passivation layer 157 may protect not only the second region 150b but also the second electrode 155.

Meanwhile, as described above, the first electrode 154 may comprise the first conductive layer 154-1, the second conductive layer 154-2, and the third conductive layer 154-3.

The first conductive layer 154-1 may surround the first region 150a. For example, the first conductive layer 154-1 may be disposed along the perimeter of the first region 150a. The first conductive layer 154-1 may comprise a conductive oxide material. For example, the first conductive layer 154-1 may comprise ITO, IZO, AZO, etc. For example, the conductive oxide material and the metal may have a multi-layer structure laminated thereon.

The second conductive layer 154-2 may be disposed on the first region 150a. The second conductive layer 154-2 may surround the first region 150a. The second conductive layer 154-2 may be disposed along the perimeter of the first region 150a. The first conductive layer 154-1 and the second conductive layer 154-2 may be vertically overlapped. The first conductive layer 154-1 and the second conductive layer 154-2 may be horizontally overlapped with the first region 150a. The second conductive layer 154-2 is a metal having excellent electrical conductivity, which not only allows current to flow from the first region 150a to the first electrode wiring 361, but also prevents current loss. The second conductive layer 154-2 may have a multi-layer structure. For example, the second conductive layer 154-2 may comprise an electrode layer. For example, the second conductive layer 154-2 may comprise a barrier layer, a reflective layer, a bonding layer, etc.

Meanwhile, since the second conductive layer 154-2 is disposed on the step portion 150c, the contact area between the second conductive layer 154-2 and the first region 150a is expanded, so that the current flow from the first region 150a to the first electrode wiring 361 may be facilitated.

The width W21 of the first conductive layer 154-1 may be greater than the width W31 of the second conductive layer 154-2. The width W21 of the first conductive layer 154-1 may be the same as the width W31 of the second conductive layer 154-2. As will be described later, during the LLO process (FIG. 15C) in the manufacturing process of a semiconductor light-emitting element, the first conductive layer 154-1 may protect the second conductive layer 154-2 from the laser. If the first conductive layer 154-1 is not present, the laser may be directly irradiated to the second conductive layer 154-2, causing the second conductive layer 154-2 to melt and be removed, and electrical characteristics of the second conductive layer 154-2, such as electrical conductivity, may deteriorate. Therefore, the first conductive layer 154-1 can protect the second conductive layer 154-2 from the laser during the LLO process, thereby maintaining the electrical characteristics or shape of the second conductive layer 154-2 as they are.

The third conductive layer 154-3 can be disposed under the first region 150a. In addition, the third conductive layer 154-3 can be disposed under the first conductive layer 154-1.

Since the third conductive layer 154-3 comprises a magnetic layer comprising a metal, it can be magnetized by a magnet. Therefore, during self-assembly, the third conductive layer 154-3 is magnetized by the assembly device (1100 of FIG. 10), so that the semiconductor light-emitting element 150-1 moves more quickly and rapidly when the assembly device 1100 moves, thereby shortening the process time and improving the assembly yield. For example, the third conductive layer 154-3 may be made of nickel (Ni), cobalt (Co), iron (Fe), etc.

In the embodiment, the third conductive layer 154-3 may be disposed not only under the first region 150a but also under the first conductive layer 154-1 having a ring shape, so that its area can be expanded, and thus the magnetization of the third conductive layer 154-3 can be increased, so that the assembly yield can be significantly improved.

In addition, since the third conductive layer 154-3 comprises a metal, it can also serve as an electrode layer for allowing current to flow smoothly.

The first conductive layer 154-1 and the second conductive layer 154-2 may have a ring shape, as illustrated in FIG. 13. That is, since the first conductive layer 154-1 and the second conductive layer 154-2 are disposed along the perimeter of the first region 150a, they can have a ring shape.

According to the embodiment, since the first conductive layer 154-1 is disposed along the perimeter of the first region 150a and is disposed between the second conductive layer 154-2 and the third conductive layer 154-3, the following various technical advantages can be achieved.

As a first example, the first conductive layer 154-1 may be an electrode layer. That is, the first conductive layer 154-1 may be made of a conductive oxide material having excellent electrical conductivity. For example, the first conductive layer 154-1 may comprise ITO, IZO,AZO, etc. Accordingly, current may easily flow from the first region 150a to the first conductive layer 154-1. In particular, since the first conductive layer 154-1 is disposed along the perimeter of the first region 150a, current may flow to the first electrode wiring 361 through the first conductive layer 154-1 in the entire region of the first region 150a. Accordingly, more electrons may be generated in the first region 150a, i.e., the first conductivity-type semiconductor layer 151, which may contribute to improved light efficiency.

In accordance with the present invention, the first conductive layer 154-1 is an ultraviolet-ray blocking layer and may furthermore be a visible-light transmitting layer. The first conductive layer 154-1 may comprise, for example, ITO, as described above.

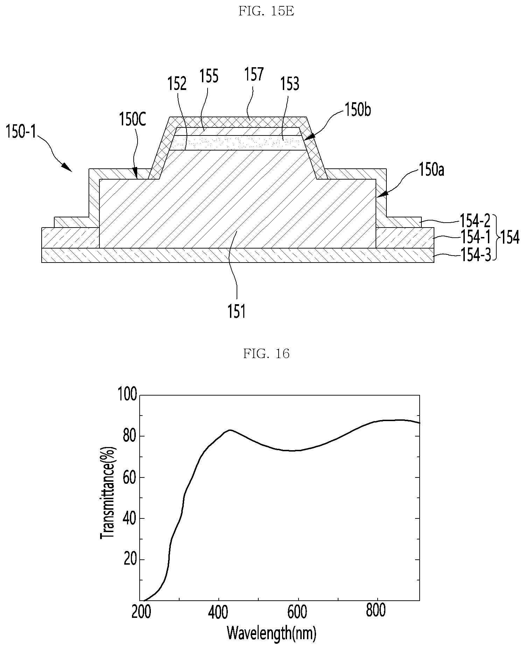

As shown in FIG. 16, in the case of ITO, the light transmittance may be 20% or less for the ultraviolet wavelength, and 70% or more for the visible-light wavelength. Therefore, the first conductive layer 154-1 may block ultraviolet light and transmit visible light.

For example, since the wavelength of the laser beam used in the LLO process (FIG. 15C) among the manufacturing processes of semiconductor light-emitting elements is an ultraviolet wavelength, when the laser beam is irradiated, the laser beam may be blocked by the first conductive layer 154-1, so that the laser beam does not pass through the first conductive layer 154-1 and may be irradiated to the second conductive layer 154-2, and thus the second conductive layer 154-2 can be protected from the laser beam.

For example, since the color light emitted from the semiconductor light-emitting element is a visible-light wavelength, the color light can be emitted to the outside by transmitting through the first conductive layer 154-1. As illustrated in FIG. 12, when the color light is emitted from the semiconductor light-emitting element through the first conductive layer 154-1, the color light may be refracted or reflected by the inner surface of the first assembling wiring 321, the second assembling wiring 322, or the partition wall 340 and emitted forward, so that uniform light output can be possible and light efficiency can be improved.

As a third example, the first conductive layer 154-1 can be a heat absorption layer. The first substrate 1000 and the semiconductor light-emitting element can be separated from each other by the LLO process (FIG. 15C) during the manufacturing process of the semiconductor light-emitting element. For example, by focusing the laser beam on the interface between the first substrate 1000 and the semiconductor light-emitting element, the temperature of the interface may be increased, and by separating, for example, Ga and N at the interface, the first substrate 1000 and the semiconductor light-emitting element can be separated from each other.

At this time, when the laser beam is irradiated, the first conductive layer 154-1 may absorb the laser beam and convert it into heat, so that the temperature can rapidly increase due to the heat within the first conductive layer 154-1. In this way, the rapidly-increased temperature can be transferred to the interface between the first substrate 1000 and the semiconductor light-emitting element through the first region 150a, thereby promoting the separation between the first substrate 1000 and the semiconductor light-emitting element.

Referring again to FIGS. 11 and 12, the plurality of first electrode wirings 361 may be connected to at least one or more of the first conductive layer 154-1, the second conductive layer 154-2, or the third conductive layer 154-3, respectively. For example, the first electrode wiring 361 may be connected to a side surface of the first conductive layer 154-1 through the first contact hole 350H1. For example, the first electrode wiring 361 may be connected to an upper surface of the second conductive layer 154-2 through the first contact hole 350H1. For example, the first electrode wiring 361 may be connected to a side surface of the second conductive layer 154-2 through the first contact hole 350H1. For example, the first electrode wiring 361 may be in contact with a side surface of the third conductive layer 154-3 through the first contact hole 350H1.

Therefore, since the current flows from the entire area of the first region 150a through the first conductive layer 154-1, the second conductive layer 154-2, and/or the third conductive layer 154-3 to the first electrode wiring 361, the light efficiency can be improved through the generation of more electrons in the first region 150a, i.e., the first conductivity-type semiconductor layer 151.

The plurality of second electrode wirings 362 can be connected to the second electrodes 155 of the plurality of semiconductor light-emitting elements 150-1, 150-2, and 150-3, respectively, through the second contact holes 35H2.

For example, when a (+) voltage is supplied through the second electrode wiring 362 and a (-) voltage is supplied through the first electrode wiring 361, current can flow through the second conductivity-type semiconductor layer 153, the active layer 152, and the first conductivity-type semiconductor layer 151 of the light-emitting portion 151, 152, and 153. In this case, since the first region 150a, i.e., the entire region of the first conductivity-type semiconductor layer 151, is in contact with the first conductive layer 154-1, the second conductive layer 154-2, and the third conductive layer 154-3 of the first electrode 154, current can flow more easily from the first region 150a to the second electrode wiring 362, so that the light efficiency can be significantly improved.

Meanwhile, the display device 300 according to the first embodiment may comprise a plurality of signal lines SL1, SL2, SL3, and SL4. The plurality of signals may comprise a first signal line SL1, a second signal line SL2, a third signal line SL3, and a fourth signal line SL4. The plurality of signal lines SL1, SL2, SL3, and SL4 may be disposed in the same layer.

The plurality of signal lines SL1, SL2, SL3, and SL4 may be disposed in a different layer from the first electrode wiring 361 and the second electrode wiring 362. Accordingly, the plurality of signal lines SL1, SL2, SL3, and SL4, the first electrode wiring 361 and the second electrode wiring 362 may be electrically connected through a plurality of contact holes 351H1, 351H2, 351H3, and 351H4. For example, the first signal line SL1 and the second electrode wiring 362 may be electrically connected through the first contact hole 351H1. For example, the second signal line SL2 and the second electrode wiring 362 may be electrically connected through the second contact hole 351H2. For example, the third signal line SL3 and the second electrode wiring 362 may be electrically connected through the third contact hole 351H3. For example, the fourth signal line SL4 and the first electrode wiring 361 may be electrically connected through the fourth contact hole 351H4.

The plurality of signal lines SL1, SL2, SL3, and SL4 may be disposed in different layers from the first assembling wiring 321 and the second assembling wiring 322.

Meanwhile, the first signal line SL1 may be electrically connected to the plurality of first sub-pixels PX1. For example, the first signal line SL1 may be electrically connected to the second electrode 155 of the first semiconductor light-emitting element 150-1 through the second electrode wiring 362 of each of the plurality of first sub-pixels PX1.

The second signal line SL2 may be electrically connected to the plurality of second sub-pixels PX2. For example, the second signal line SL2 may be electrically connected to the second electrode 155 of the second semiconductor light-emitting element 150-2 through the second electrode wiring 362 of each of the plurality of second sub-pixels PX2.

The third signal line SL3 may be electrically connected to the plurality of third sub-pixels PX3. For example, the third signal line SL3 may be electrically connected to the second electrode 155 of the third semiconductor light-emitting element 150-3 through the second electrode wiring 362 of each of the plurality of third sub-pixels PX3.

The fourth signal line SL4 may be commonly connected to the first sub-pixel PX1, the second sub-pixel PX2, and the third sub-pixel PX3. For example, the fourth signal line SL4 may be electrically connected to the first electrode 154 of the first semiconductor light-emitting element 150-1 through the first electrode wiring 361 of the first sub-pixel PX1. For example, the fourth signal line SL4 may be electrically connected to the first electrode 154 of the second semiconductor light-emitting element 150-2 through the first electrode wiring 361 of the second sub-pixel PX2. For example, the fourth signal line SL4 may be electrically connected to the first electrode 154 of the third semiconductor light-emitting element 150-3 through the first electrode wiring 361 of the third sub-pixel PX3.

For example, the first signal line SL1, the second signal line SL2, and the third signal line SL3 may each be supplied with a positive voltage. For example, the fourth signal line SL4 may be grounded or supplied with a negative voltage. The positive voltages supplied to the first signal line SL1, the second signal line SL2, and the third signal line SL3 may be the same, but are not limited thereto.

For example, the first signal line SL1 connected to the first sub-pixel PX1 may be a high-potential voltage line VDDL as shown in FIG. 7. For example, the second signal line SL2 connected to the second sub-pixel PX2 and the third signal line SL3 connected to the third sub-pixel PX3 may also be high-potential signal lines VDDL and supplied with a high-potential voltage (VDD of FIG. 6). For example, the fourth signal line SL4, which is commonly connected to each of the first sub-pixel PX1, the second sub-pixel PX2, and the third sub-pixel PX3, may be a low-potential signal line VSSL to which a low-potential voltage (VSS of FIG. 6) may be supplied.

Although not shown in the drawing, a driving transistor (DT of FIG. 7) may be provided between the first signal line SL1 and the first semiconductor light-emitting element 150-1 of the first sub-pixel PX1, the second signal line SL2 and the second semiconductor light-emitting element 150-2 of the second sub-pixel PX2, and the third signal line SL3 and the third semiconductor light-emitting element 150-3 of the third sub-pixel PX3. At this time, the gate terminal of the driving transistor DT may be connected to the data line Dj via the scan transistor ST.

Therefore, the first sub-pixel PX1, the second sub-pixel PX2, and the third sub-pixel PX3 may each be provided with a scan transistor ST, a driving transistor DT, and semiconductor light-emitting elements 150-1, 150-2, and 150-3. At this time, the driving transistor DT may be connected to the scan transistor ST and the semiconductor light-emitting elements 150-1, 150-2, and 150-3, and the scan transistor ST may be connected to the data line Dj. The driving transistors ST of the first sub-pixel PX1, the second sub-pixel PX2, and the third sub-pixel PX3 may be connected to the high-potential signal line VDDL, that is, the first to third signal lines SL1, SL2, and SL3, respectively. The semiconductor light-emitting elements 150-1, 150-2 and 150-3 of the first sub-pixel PX1, the second sub-pixel PX2 and the third sub-pixel PX3 can each be connected to a low-potential signal line VSSL, i.e., the fourth signal line SL4.

The current flowing through the driving transistor ST becomes different depending on the data voltage supplied to the data line Dj, and the light intensity, i.e., luminance or gradation, of the semiconductor light-emitting elements 150-1, 150-2 and 150-3 of the first sub-pixel PX1, the second sub-pixel PX2 and the third sub-pixel PX3 becomes different due to the different currents, so that images having different brightness can be displayed.

Hereinafter, a manufacturing process of a semiconductor light-emitting element according to an embodiment will be described with reference to FIGS. 15A to 15E.

FIGS. 15A to 15E illustrate a manufacturing process of a semiconductor light-emitting element according to an embodiment.

As illustrated in FIG. 15A, light-emitting portion 151, 152, and 153 may be formed on a first substrate 1000, and a passivation layer 157 may be formed on one side of the light-emitting portion 151, 152, and 153. The first substrate 1000 may be a growth substrate for growing the first conductivity-type semiconductor layer 151, the active layer 152, and the second conductivity-type semiconductor layer 153 of the light-emitting portion 151, 152, and 153.

Specifically, as illustrated in FIG. 15A, the first conductivity-type semiconductor layer 151, the active layer 152, and the second conductivity-type semiconductor layer 153 may be sequentially deposited on the first substrate 1000. The first conductivity-type semiconductor layer 151, the active layer 152, and the second conductivity-type semiconductor layer 153 may be deposited, for example, using an MOCVD equipment. For example, the first substrate 1000 may be a semiconductor growth substrate, such as sapphire or GaAs. Each of the first conductivity-type semiconductor layer 151, the active layer 152, and the second conductivity-type semiconductor layer 153 may comprise at least or more one layer.

Although not shown, a third semiconductor layer may be deposited before depositing the first conductivity-type semiconductor layer 151. The third semiconductor layer is an undoped semiconductor layer that does not comprise a dopant, and may serve as a seed to facilitate the growth of the first conductivity-type semiconductor layer 151, the active layer 152, and the second conductivity-type semiconductor layer 153.

An etching process may be performed to form light-emitting portion 151, 152, and 153 having a second region 150b, a step portion 150c, and a first region 150a. The second region 150b may be subjected to mesa etching to increase in diameter from the upper side to the lower side. Through such an etching process, a plurality of light-emitting portions 151, 152, and 153 spaced apart from each other may be formed on the first substrate 1000.

A diameter D11 of the first region 150a may be greater than a diameter D12 of the second region 150b. A step portion 150c may be formed between the first region 150a and the second region 150b. The step portion 150c may be an upper surface exposed on the upper side of the first region 150a.

Afterwards, a passivation layer 157 may be formed around the first region 150a. For example, the passivation layer 157 may be formed on the upper side of the first region 150a and along the perimeter of the side portion of the first region 150a.

The passivation layer 157 may prevent an electrical short between the first conductivity-type semiconductor layer 151 and the second conductivity-type semiconductor layer 153 due to a foreign substance. The passivation layer 157 may prevent leakage current flowing through the side portion of each of the first conductivity-type semiconductor layer 151 and the second conductivity-type semiconductor layer 153. The passivation layer 157 may allow the semiconductor light-emitting elements (150-1, 150-2, 150-3 of FIG. 11) to be properly assembled without being flipped during self-assembly.

The passivation layer 157 may be an inorganic material, for example, SiNₓ or SiOₓ.

Meanwhile, the second electrode 155 may be formed on the second conductivity-type semiconductor layer 153. The second electrode 155 may be formed on the second conductivity-type semiconductor layer 153 before the light-emitting portion 151, 152, and 153 are formed. Thereafter, after the second electrode 155 is patterned, an etching process may be performed using the second electrode 155 as a mask, thereby forming the light-emitting portion 151, 152, and 153.

As another example, after the light-emitting portion 151, 152, and 153 are formed, the second electrode 155 may be formed on the second conductivity-type semiconductor layer 153.

The second electrode 155 may be formed of a conductive oxide material that transmits light, i.e., visible light. As described above, ITO, IZO, etc. may be used as the conductive oxide material.

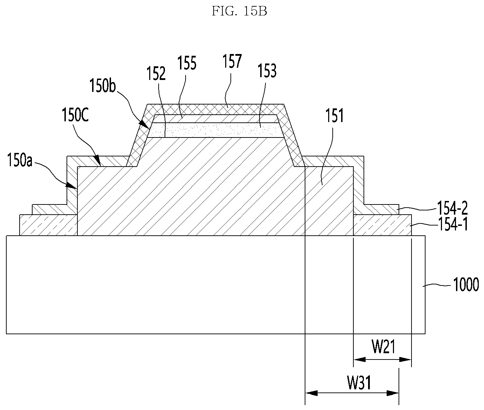

As illustrated in FIG. 15B, a photolithography process may be performed to form the first conductive layer 154-1 and the second conductive layer 154-2.

For example, after a conductive oxide film and a metal film are deposited on the first substrate 1000, a photolithography process may be performed to sequentially remove the metal film and the conductive oxide film, thereby forming the first conductive layer 154-1 and the second conductive layer 154-2. At this time, the width W21 of the first conductive layer 154-1 may be greater than the width W31 of the second conductive layer 154-2. For example, the first conductive layer 154-1 may be formed to extend outwardly from the end of the second conductive layer 154-2.

The first conductive layer 154-1 may be formed along the perimeter of the side portion of the first region 150a of the light-emitting portion 151, 152, and 153, and the second conductive layer 154-2 may be formed on the second conductive layer 154-2 and may be formed along the perimeter of the side portion of the first region 150a. In addition, the second conductive layer 154-2 may be formed on the step portion 150c.

For example, the first conductive layer 154-1 may be formed of a conductive oxide material such as ITO, and the second conductive layer 154-2 may have a multi-layer structure comprising a plurality of different metals. For example, the second conductive layer 154-2 may comprise a metal layer, a reflective layer, etc.

As shown in FIG. 15C, the second substrate 1010 can be bonded to the upper side of the light-emitting portion 151, 152, and 153.

Afterwards, the LLO process is performed so that the light-emitting portion 151, 152, and 153 and the first substrate 1000 can be separated from each other. At this time, the light-emitting portion 151, 152, and 153 can still be bonded to the second substrate 1010. As the first substrate 1000 is separated, the surface of the first conductivity-type semiconductor layer 151 and the surface of the first conductive layer 154-1 can be exposed to the outside.

That is, the laser beam can be irradiated to the light-emitting portion 151, 152, and 153 through the first substrate 1000. At this time, the laser beam can be focused on the interface between the first substrate 1000 and the light-emitting portion 151, 152 and 153. Accordingly, the laser beam may be irradiated to the interface between the first substrate 1000 and the light-emitting portion 151, 152 and 153 in a concentrated manner, so that the temperature of the interface can rapidly increase, and Ga and N of the light-emitting portion 151, 152 and 153 adjacent to the interface can be separated, so that the first substrate 1000 can be separated from the light-emitting portion 151, 152 and 153.

Meanwhile, the laser beam can also be irradiated to the first conductive layer 154-1 through the first substrate 1000.

As described above, the first conductive layer 154-1 is a conductive oxide material, and as illustrated in FIG. 16, the light transmittance of ITO may vary depending on the wavelength. For example, light of an ultraviolet wavelength may have a light transmittance of 20% or less, which is close to 0, and light of a visible-light wavelength may have a light transmittance of 70%. Accordingly, the first conductive layer 154-1 functions as an ultraviolet blocking layer for light of an ultraviolet wavelength, and as a visible-light transmitting layer for light of a visible-light wavelength.

For example, when a KrF (248 nm) laser is used to perform the LLO process, when the laser beam is irradiated to the first conductive layer 154-1 through the first substrate 1000, the laser beam may be blocked by the first conductive layer 154-1 and does not proceed any further. Accordingly, since the laser beam is blocked by the first conductive layer 154-1, the second conductive layer 154-2 is not irradiated with the laser beam. If the laser beam is irradiated to the second conductive layer 154-2, the second conductive layer 154-2 may melt or its electrical and/or chemical properties may be deformed, so that it can no longer function as the second conductive layer 154-2, for example, as an electrode layer. Therefore, the first conductive layer 154-1 can serve as a protective layer that protects the second conductive layer 154-2 from the laser beam.

In order to prevent the laser beam from being transmitted to the second conductive layer 154-2, as described above, the width W21 of the first conductive layer 154-1 can be greater than the width W31 of the second conductive layer 154-2.

As illustrated in FIG. 15D, the third conductive layer 154-3 can be formed on each of the exposed surfaces of the first conductive type semiconductor layer 151 and the first conductive layer 154-1. The third conductive layer 154-3 may comprise a ferromagnetic metal having excellent magnetization characteristics. The third conductive layer 154-3 may comprise a metal having excellent electrical conductivity. The third conductive layer 154-3 may comprise at least one or more layer.

In order to move the semiconductor light-emitting elements (150-1, 150-2, 150-3 of FIG. 11) in the fluid more quickly during the self-assembly process, the magnetization of the magnetic layers of the semiconductor light-emitting elements 150-1, 150-2, and 150-3, i.e., the third conductive layer 154-3, must be high. In order to increase the magnetization of the third conductive layer 154-3, the thickness or the area may be increased.

In the embodiment, the third conductive layer 154-3 may be formed not only on the first conductivity-type semiconductor layer 151 but also on the first conductive layer 154-1, so that the area of the third conductive layer 154-3 can be expanded, thereby increasing the magnetization. Accordingly, the semiconductor light-emitting elements 150-1, 150-2, and 150-3 can be quickly moved by the movement of the magnet during the self-assembly process, so that the assembly yield can be improved.

Although not illustrated, the third conductive layer 154-3 may be formed along the perimeter of the side portion of the first conductive layer 154-1. Although not illustrated, the third conductive layer 154-3 may be formed along the perimeter of the side portion of the second conductive layer 154-2. Accordingly, the area of the third conductive layer 154-3 is further expanded, thereby significantly improving the assembly yield. In addition, as the third conductive layer 154-3 surround the side portion of the first conductive layer 154-1 and the side portion of the third conductive layer 154-3, the bonding strength or fixing property with the light-emitting portion 151, 152, and 153 can be strengthened, so that the reliability of the product quality of the semiconductor light-emitting elements 150-1, 150-2, and 150-3 can be improved.

The first conductive layer 154-1, the second conductive layer 154-2, and the third conductive layer 154-3 can form the first electrode 154.

As illustrated in FIG. 15E, the first semiconductor light-emitting element 150-1 can be manufactured by removing the second substrate 1010.

Although not shown, the second substrate 1010 may have a sacrificial layer, such as aluminum (Al), provided between the second substrate 1010 and the light-emitting portion 151, 152, and 153. For example, a wet etching process may be performed to remove the sacrificial layer, thereby separating the second substrate 1010 and the light-emitting portion 151, 152, and 153 from each other. The light-emitting portion 151, 152, and 153 may form the first semiconductor light-emitting element 150-1 together with the first electrode 154, the second electrode 155, and the passivation layer 157.

Although FIGS. 15A to 15E illustrate a manufacturing process of the first semiconductor light-emitting element 150-1, the second semiconductor light-emitting element 150-2 and the third semiconductor light-emitting element 150-3 can also be manufactured by applying the manufacturing process illustrated in FIGS. 15A to 15E in the same manner.

### [Second Embodiment]

FIG. 17 is a plan view illustrating a display device according to the second embodiment. FIG. 18 is a cross-sectional view taken along the line E1-E2 of FIG. 17.

The second embodiment is similar to the first embodiment except that the side of each of the semiconductor light-emitting elements 150-1, 150-2, and 150-3 is connected using the connection electrode 370. In the second embodiment, the same drawing reference numerals are given to components having the same shape, structure, and/or function as those of the first embodiment, and detailed descriptions are omitted.

Referring to FIG. 17 and FIG. 18, the display device 301 according to the second embodiment may comprise a substrate 310, a plurality of first assembling wirings 321, a plurality of second assembling wirings 322, a partition wall 340, a plurality of semiconductor light-emitting elements 150-1, 150-2, and 150-3, and a plurality of connection electrodes 370.

A plurality of sub-pixels PX1, PX2, and PX3 may be arranged on the substrate.

As illustrated in FIG. 18, the first sub-pixel PX1 may comprise a first assembling wiring 321, a second assembling wiring 322, an assembly hole 340H, a first semiconductor light-emitting element 150-1, a connection electrode 370, and an electrode wiring 362. Although not shown, the second sub-pixel PX2 and the third sub-pixel PX3 may also comprise components of the first sub-pixel PX1 as they are.

The first semiconductor light-emitting element 150-1 may be manufactured by the manufacturing process shown in FIGS. 15A to 15E.

For example, the first semiconductor light-emitting element 150-1 may be assembled into the assembly hole 340H through a self-assembly process. That is, a dielectrophoretic force may be formed by the voltage supplied to the first assembling wiring 321 and the second assembling wiring 322 during self-assembly. That is, a dielectrophoretic force may be formed in the assembly hole 340H. The first semiconductor light-emitting element 150-1 may be moved by a magnet in a fluid and then inserted into the assembly hole 340H by the dielectrophoretic force formed in the assembly hole 340H of the first sub-pixel PX1. The first semiconductor light-emitting element 150-1 inserted into the assembly hole 340H can be fixed by the dielectrophoretic force.

Even if the voltage supplied to the first assembling wiring 321 and the second assembling wiring 322 is cut off after the fluid is removed and then the dielectrophoretic force disappears, the first semiconductor light-emitting element 150-1 can still be fixed within the assembly hole 340H by the van der Waals force between the first semiconductor light-emitting element 150-1 and a bottom portion within the assembly hole 340H.

Thereafter, the first insulating layer 320 exposed around the first semiconductor light-emitting element 150-1 within the assembly hole 340H can be removed through an etching process, thereby exposing the first assembling wiring 321 and/or the second assembling wiring 322.

Afterwards, a metal film may be deposited and patterned to be formed along the perimeter of the first semiconductor light-emitting element 150-1 within the assembly hole 340H. Accordingly, the first electrode 154 of the first semiconductor light-emitting element 150-1 and the first assembling wiring 321 and/or the second assembling wiring 322 may be connected by the connection electrode 370. In this case, the first assembling wiring 321 and/or the second assembling wiring 322 may be connected to the fourth signal line SL4 through the contact hole 352.

The thickness of the connection electrode 370 may be smaller than the thickness of the partition wall 340, but is not limited thereto.

The connection electrode 370 may be connected to the first conductive layer 154-1 of the first electrode 154. For example, the connection electrode 370 may be connected to a side surface of the first conductive layer 154-1 of the first electrode 154. The connection electrode 370 may be connected to a second conductive layer 154-2 of the first electrode 154. For example, the connection electrode 370 may be connected to an upper surface and a side surface of the second conductive layer 154-2 of the first electrode 154. For example, the connection electrode 370 may cover an entire area of the second conductive layer 154-2 of the first electrode 154. The connection electrode 370 may be connected to a third conductive layer 154-3 of the first electrode 154. For example, the connection electrode 370 may be connected to a side surface of the third electrode of the first electrode 154.

Therefore, since the current flows from the entire area of the first region 150a through the first conductive layer 154-1, the second conductive layer 154-2, and/or the third conductive layer 154-3 to the connection electrode 370, the light efficiency can be improved through the generation of more electrons in the first region 150a, i.e., the first conductivity-type semiconductor layer 151.

In addition, since the connection electrode 370 is disposed along the perimeter of the semiconductor light-emitting elements 150-1, 150-2, and 150-3 within the assembly hole 340H, the partition wall 340 and the semiconductor light-emitting elements 150-1, 150-2, and 150-3 may be firmly fixed by the connection electrode 370, so that the fixation can be strengthened.

Afterwards, a second insulating layer 350 may be formed on the partition wall 340 and the first semiconductor light-emitting element 150-1, and an electrode wiring 362 may be formed on the second insulating layer 350. The electrode wiring 362 may be connected to the second electrode 155 of the first semiconductor light-emitting element 150-1 through a contact hole 350H2 formed in the second insulating layer 350.

In this case, the first assembling wiring 321 and/or the second assembling wiring 322 may be used as the first electrode wiring 361, and the electrode wiring 362 may be the second electrode wiring 362. Accordingly, the first semiconductor light-emitting element may emit a first color light, for example, a red light, by a voltage applied between the first assembling wiring 321 and/or the second assembling wiring 322 and the electrode wiring 362.

Meanwhile, the display device described above may be a display panel. That is, in the embodiment, the display device and the display panel may be understood to have the same meaning. In the embodiment, the display device in a practical meaning may comprise a display panel and a controller (or processor) that can control the display panel to display an image.

The above detailed description should not be construed as limiting in all respects and should be considered illustrative. The scope of the present invention is defined by the appended claims.

### [Industrial Applicability]

The present invention can be adopted in the display field for displaying images or information. The present invention can be adopted in the display field for displaying images or information using a semiconductor light-emitting element. The semiconductor light-emitting element can be a micro-level semiconductor light-emitting element or a nano-level semiconductor light-emitting element.

For example, the present invention can be adopted in a TV, signage, a smart phone, a mobile phone, a mobile terminal, a HUD for a car, a backlight unit for a notebook, a display device for VR or AR.

## Claims

1. A semiconductor light-emitting element (150-1, 150-2, 150-3), comprising:
a light-emitting portion (151, 152, 153) comprising a first region (150a) and a second region (150b) on the first region (150a);
a first electrode (154) under the first region (150a);
a second electrode (155) on the second region (150b); and
a passivation layer (157) configured to surround the second region (150b),
wherein the first electrode (154) comprises:
a first conductive layer (154-1) configured to surround the first region (150a);
a second conductive layer (154-2) disposed on the first conductive layer (154-1) and configured to surround the first region (150a); and
a third conductive layer (154-3) under the first region (150a) and the first conductive layer (154-1),
wherein the first conductive layer (154-1), the second conductive layer (154-2) and the third conductive layer (154-3) are configured to be vertically overlapped with each other along the perimeter of the first region (150a), and
wherein the first conductive layer (154-1) is an ultraviolet-ray blocking layer.

2. The semiconductor light-emitting element (150-1, 150-2, 150-3) of claim 1, wherein the first conductive layer (154-1) is an electrode layer.

3. The semiconductor light-emitting element (150-1, 150-2, 150-3) of claim 1 or 2, wherein the first conductive layer (154-1) is a visible-light transmitting layer.

4. The semiconductor light-emitting element (150-1, 150-2, 150-3) of one of the preceding claims, wherein the first conductive layer (154-1) is a heat absorption layer.

5. The semiconductor light-emitting element (150-1, 150-2, 150-3) of one of the preceding claims, wherein the first conductive layer (154-1) comprises a conductive oxide material.

6. The semiconductor light-emitting element (150-1, 150-2, 150-3) of one of the preceding claims, wherein the light-emitting element comprises:
a first conductivity-type semiconductor layer (151);
an active layer (152) on the first conductivity-type semiconductor layer (151); and
a second conductivity-type semiconductor layer (153) on the active layer (152),
wherein the first region (150a) comprises the first conductivity-type semiconductor layer (151), and
wherein the second region (150b) comprises the active layer (152) and the second conductivity-type semiconductor layer (153).

7. A display device (300), comprising:
a substrate (310) comprising a plurality of sub-pixels (PX1, PX2, PX3);
a plurality of first assembling wirings (321) in the plurality of sub-pixels (PX1, PX2, PX3), respectively;
a plurality of second assembling wirings (322) in the plurality of sub-pixels (PX1, PX2, PX3), respectively;
a partition wall (340) having a plurality of assembly holes (340H) in the plurality of sub-pixels (PX1, PX2, PX3), respectively;
a plurality of semiconductor light-emitting elements (150-1, 150-2, 150-3) according to claim 1, in the plurality of assembly holes (340H), respectively;
a plurality of first electrode wirings (361) on first sides of upper sides of the plurality of semiconductor light-emitting elements (150-1, 150-2, 150-3), respectively;
a plurality of second electrode wirings (362) on second sides of the upper sides of each of the plurality of semiconductor light-emitting elements (150-1, 150-2, 150-3), respectively.

8. The display device of claim 7, wherein each of the plurality of first electrode wirings (361) is connected to at least one or more conductive layer of the first conductive layer (154-1), the second conductive layer (154-2), or the third conductive layer (154-3), and
wherein the plurality of second electrode wirings (362) are connected to the second electrodes (155) of the plurality of semiconductor light-emitting elements (150-1, 150-2, 150-3), respectively.

9. A display device (301), comprising:
a substrate (300) comprising a plurality of sub-pixels (PX1, PX2, PX3);
a plurality of first assembling wirings (321) in the plurality of sub-pixels (PX1, PX2, PX3), respectively;
a plurality of second assembling wirings (322) in the plurality of sub-pixels (PX1, PX2, PX3), respectively;
a partition wall (340) having a plurality of assembly holes (340H) in the plurality of sub-pixels (PX1, PX2, PX3), respectively;
a plurality of semiconductor light-emitting elements (150-1, 150-2, 150-3) according to claim 1, in the plurality of assembly holes (340H), respectively; and
a connection electrode (370) configured to surround a side portion of each of the plurality of semiconductor light-emitting elements (150-1, 150-2, 150-3);
an electrode wiring (362) on an upper side of each of the plurality of semiconductor light-emitting elements (150-1, 150-2, 150-3).

10. The display device (301) of claim 9, wherein the connection electrode (370) is configured to connect at least one assembling wiring of the first assembling wiring (321) or the second assembling wiring (322) to at least one or more of the first conductive layer (154-1), the second conductive layer (154-2), or the third conductive layer (154-3).

## Patentansprüche

1. Lichtemittierendes Halbleiterelement (150-1, 150-2, 150-3), umfassend:
einen lichtemittierenden Abschnitt (151, 152, 153), der einen ersten Bereich (150a) und einen zweiten Bereich (150b) auf dem ersten Bereich (150a) umfasst;
eine erste Elektrode (154) unter dem ersten Bereich (150a);
eine zweite Elektrode (155) auf dem zweiten Bereich (150b); und
eine Passivierungsschicht (157), die dazu eingerichtet ist, den zweiten Bereich (150b) zu umgeben,
wobei die erste Elektrode (154) umfasst:
eine erste leitfähige Schicht (154-1), die dazu eingerichtet ist, den ersten Bereich (150a) zu umgeben;
eine zweite leitfähige Schicht (154-2), die auf der ersten leitfähigen Schicht (154-1) angeordnet und dazu eingerichtet ist, den ersten Bereich (150a) zu umgeben; und
eine dritte leitfähige Schicht (154-3) unter dem ersten Bereich (150a) und der ersten leitfähigen Schicht (154-1),
wobei die erste leitfähige Schicht (154-1), die zweite leitfähige Schicht (154-2) und die dritte leitfähige Schicht (154-3) dazu eingerichtet sind, entlang des Umfangs des ersten Bereichs (150a) in vertikaler Richtung miteinander überlappend angeordnet zu sein, und
wobei die erste leitfähige Schicht (154-1) eine Ultraviolettstrahlung blockierende Schicht ist.

2. Lichtemittierendes Halbleiterelement (150-1, 150-2, 150-3) nach Anspruch 1, wobei die erste leitfähige Schicht (154-1) eine Elektrodenschicht ist.

3. Lichtemittierendes Halbleiterelement (150-1, 150-2, 150-3) nach Anspruch 1 oder 2, wobei die erste leitfähige Schicht (154-1) eine Schicht ist, welche sichtbares Licht transmittiert.

4. Lichtemittierendes Halbleiterelement (150-1, 150-2, 150-3) nach einem der vorstehenden Ansprüche, wobei die erste leitfähige Schicht (154-1) eine Wärmeabsorptionsschicht ist.

5. Lichtemittierendes Halbleiterelement (150-1, 150-2, 150-3) nach einem der vorstehenden Ansprüche, wobei die erste leitfähige Schicht (154-1) ein leitfähiges Oxidmaterial umfasst.

6. Lichtemittierendes Halbleiterelement (150-1, 150-2, 150-3) nach einem der vorstehenden Ansprüche, wobei das lichtemittierende Element umfasst:
eine Halbleiterschicht eines ersten Leitfähigkeitstyps (151);
eine aktive Schicht (152) auf der Halbleiterschicht des ersten Leitfähigkeitstyps (151); und
eine Halbleiterschicht eines zweiten Leitfähigkeitstyps (153) auf der aktiven Schicht (152),
wobei der erste Bereich (150a) die Halbleiterschicht des ersten Leitfähigkeitstyps (151) umfasst, und
wobei der zweite Bereich (150b) die aktive Schicht (152) und die Halbleiterschicht des zweiten Leitfähigkeitstyps (153) umfasst.

7. Anzeigevorrichtung (300), umfassend:
ein Substrat (310), das eine Mehrzahl von Subpixeln (PX1, PX2, PX3) umfasst;
eine Mehrzahl erster Montageverdrahtungen (321) jeweils in der Mehrzahl von Subpixeln (PX1, PX2, PX3);
eine Mehrzahl zweiter Montageverdrahtungen (322) jeweils in der Mehrzahl von Subpixeln (PX1, PX2, PX3);
eine Trennwand (340) mit einer Mehrzahl von Montageöffnungen (340H) jeweils in der Mehrzahl von Subpixeln (PX1, PX2, PX3);
eine Mehrzahl lichtemittierender Halbleiterelemente (150-1, 150-2, 150-3) gemäß Anspruch 1, jeweils in der Mehrzahl von Montageöffnungen (340H);
eine Mehrzahl erster Elektrodenverdrahtungen (361) jeweils auf ersten Seiten der Oberseiten der Mehrzahl der lichtemittierenden Halbleiterelemente (150-1, 150-2, 150-3);
eine Mehrzahl zweiter Elektrodenverdrahtungen (362) jeweils auf zweiten Seiten der Oberseiten jedes der Mehrzahl von lichtemittierenden Halbleiterelemente (150-1, 150-2, 150-3).

8. Anzeigevorrichtung nach Anspruch 7, wobei jede der Mehrzahl der ersten Elektrodenverdrahtungen (361) mit der ersten leitfähigen Schicht (154-1) und/oder der zweiten leitfähigen Schicht (154-2) und/oder der dritten leitfähigen Schicht (154-3) verbunden ist, und
wobei die Mehrzahl der zweiten Elektrodenverdrahtungen (362) jeweils mit den zweiten Elektroden (155) der Mehrzahl der lichtemittierenden Halbleiterelemente (150-1, 150-2, 150-3) verbunden sind.

9. Anzeigevorrichtung (301), umfassend:
ein Substrat (300), das eine Mehrzahl von Subpixeln (PX1, PX2, PX3) umfasst;
eine Mehrzahl erster Montageverdrahtungen (321) jeweils in der Mehrzahl von Subpixeln (PX1, PX2, PX3);
eine Mehrzahl zweiter Montageverdrahtungen (322) jeweils in der Mehrzahl von Subpixeln (PX1, PX2, PX3);
eine Trennwand (340) mit einer Mehrzahl von Montageöffnungen (340H) jeweils in der Mehrzahl von Subpixeln (PX1, PX2, PX3);
eine Mehrzahl lichtemittierender Halbleiterelemente (150-1, 150-2, 150-3) gemäß Anspruch 1, jeweils in der Mehrzahl von Montageöffnungen (340H); und
eine Verbindungselektrode (370), die dazu eingerichtet ist, einen Seitenabschnitt jedes der Mehrzahl von lichtemittierenden Halbleiterelementen (150-1, 150-2, 150-3) zu umgeben;
eine Elektrodenverdrahtung (362) auf einer Oberseite jedes der Mehrzahl von lichtemittierenden Halbleiterelementen (150-1, 150-2, 150-3).

10. Anzeigevorrichtung (301) nach Anspruch 9, wobei die Verbindungselektrode (370) dazu eingerichtet ist, mindestens eine Montageverdrahtung aus der ersten Montageverdrahtung (321) oder der zweiten Montageverdrahtung (322) mit der ersten leitfähigen Schicht (154-1) und/oder der zweiten leitfähigen Schicht (154-2) und/oder der dritten leitfähigen Schicht (154-3) zu verbinden.

## Revendications

1. Élément semi-conducteur électroluminescent (150-1, 150-2, 150-3), comprenant :
une partie électroluminescente (151, 152, 153) qui comprend une première région (150a) et une deuxième région (150b) sur la première région (150a) ;
une première électrode (154) sous la première région (150a) ;
une deuxième électrode (155) sur la deuxième région (150b) ; et
une couche de passivation (157) configurée pour entourer la deuxième région (150b),
dans lequel la première électrode (154) comprend :
une première couche conductrice (154-1) configurée pour entourer la première région (150a) ;
une deuxième couche conductrice (154-2) disposée sur la première couche conductrice (154-1) et configurée pour entourer la première région (150a) ; et
une troisième couche conductrice (154-3) sous la première région (150a) et la première couche conductrice (154-1),
dans lequel la première couche conductrice (154-1), la deuxième couche conductrice (154-2) et la troisième couche conductrice (154-3) sont configurées pour être disposées de manière à se chevaucher mutuellement dans la direction verticale le long du pourtour de la première région (150a), et
dans lequel la première couche conductrice (154-1) est une couche bloquant le rayonnement ultraviolet.

2. Élément semi-conducteur électroluminescent (150-1, 150-2, 150-3) selon la revendication 1, dans lequel la première couche conductrice (154-1) est une couche d'électrode.

3. Élément semi-conducteur électroluminescent (150-1, 150-2, 150-3) selon la revendication 1 ou 2, dans lequel la première couche conductrice (154-1) est une couche transmettant la lumière visible.

4. Élément semi-conducteur électroluminescent (150-1, 150-2, 150-3) selon l'une des revendications précédentes, dans lequel la première couche conductrice (154-1) est une couche d'absorption de chaleur.

5. Élément semi-conducteur électroluminescent (150-1, 150-2, 150-3) selon l'une des revendications précédentes, dans lequel la première couche conductrice (154-1) comprend un matériau d'oxyde conducteur.

6. Élément semi-conducteur électroluminescent (150-1, 150-2, 150-3) selon l'une des revendications précédentes, dans lequel l'élément électroluminescent comprend :
une couche semi-conductrice d'un premier type de conductivité (151) ;
une couche active (152) sur la couche semi-conductrice du premier type de conductivité (151) ; et
une couche semi-conductrice d'un deuxième type de conductivité (153) sur la couche active (152),
dans lequel la première région (150a) comprend la couche semi-conductrice du premier type de conductivité (151), et
dans lequel la deuxième région (150b) comprend la couche active (152) et la couche semi-conductrice du deuxième type de conductivité (153).

7. Dispositif d'affichage (300), comprenant :
un substrat (310) qui comprend une pluralité de sous-pixels (PX1, PX2, PX3) ;
une pluralité de premiers câblages de montage (321) respectivement dans la pluralité de sous-pixels (PX1, PX2, PX3) ;
une pluralité de deuxièmes câblages de montage (322) respectivement dans la pluralité de sous-pixels (PX1, PX2, PX3) ;
une paroi de séparation (340) comportant une pluralité d'ouvertures de montage (340H) respectivement dans la pluralité de sous-pixels (PX1, PX2, PX3) ;
une pluralité d'éléments semi-conducteurs électroluminescents (150-1, 150-2, 150-3) selon la revendication 1 respectivement dans la pluralité d'ouvertures de montage (340H) ;
une pluralité de premiers câblages d'électrode (361) respectivement sur de premiers côtés des faces supérieures de la pluralité d'éléments semi-conducteurs électroluminescents (150-1, 150-2, 150-3) ;
une pluralité de deuxièmes câblages d'électrode (362) respectivement sur de deuxièmes côtés des faces supérieures de chacun de la pluralité des éléments semi-conducteurs électroluminescents (150-1, 150-2, 150-3).

8. Dispositif d'affichage selon la revendication 7, dans lequel chacun des premiers câblages d'électrode (361) de la pluralité est connecté à la première couche conductrice (154-1) et/ou à la deuxième couche conductrice (154-2) et/ou à la troisième couche conductrice (154-3), et
dans lequel les deuxièmes câblages d'électrode (362) de la pluralité sont respectivement connectés aux deuxièmes électrodes (155) de la pluralité d'éléments semi-conducteurs électroluminescents (150-1, 150-2, 150-3).

9. Dispositif d'affichage (301), comprenant :
un substrat (300) qui comprend une pluralité de sous-pixels (PX1, PX2, PX3) ;
une pluralité de premiers câblages de montage (321) respectivement dans la pluralité de sous-pixels (PX1, PX2, PX3) ;
une pluralité de deuxièmes câblages de montage (322) respectivement dans la pluralité de sous-pixels (PX1, PX2, PX3) ;
une paroi de séparation (340) comportant une pluralité d'ouvertures de montage (340H) respectivement dans la pluralité de sous-pixels (PX1, PX2, PX3) ;
une pluralité d'éléments semi-conducteurs électroluminescents (150-1, 150-2, 150-3) selon la revendication 1 respectivement dans la pluralité d'ouvertures de montage (340H) ; et
une électrode de connexion (370) configurée pour entourer une partie latérale de chacun de la pluralité des éléments semi-conducteurs électroluminescents (150-1, 150-2, 150-3) ;
un câblage d'électrode (362) sur une face supérieure de chacun de la pluralité des éléments semi-conducteurs électroluminescents (150-1, 150-2, 150-3).

10. Dispositif d'affichage (301) selon la revendication 9, dans lequel l'électrode de connexion (370) est configurée pour connecter au moins un câblage de montage parmi le premier câblage de montage (321) ou le deuxième câblage de montage (322) à la première couche conductrice (154-1) et/ou à la deuxième couche conductrice (154-2) et/ou à la troisième couche conductrice (154-3).
